# EUROPEAN PATENT SPECIFICATION

(11) **EP 1 767 995 B1**
(45) Date of publication and mention of the grant of the patent: **22.01.2014**
(21) Application number: 06016331.8
(22) Date of filing: 04.08.2006
(51) Int. Cl.: G03F 7/16, G03F 7/027

(54) **Method of producing photosensitive planographic printing plate precursor**
Verfahren zur Herstellung lichtempfindlicher Flachdruckplattenvorläufer
Procédé de fabrication du précurseur de plaque d'impression planographique photosensible

(30) Priority: 26.09.2005 JP 2005278766
(43) Date of publication of application: 28.03.2007
(73) Proprietor: FUJIFILM Corporation, Minato-ku Tokyo (JP)
(72) Inventor: Kuwabara, Katsushi, Yoshida-cho Haibara-gun Shizuoka (JP)
(74) Representative: HOFFMANN EITLE

(56) References cited:
- EP-A- 1 502 735
- EP-A- 1 564 591
- US-A1- 2005 131 184
- DATABASE WPI Week 200482 Derwent Publications Ltd., London, GB; AN 2004-825298 XP002419997 & JP 2004 321898 A (MITSUBISHI RAYON CO LTD) 18 November 2004 (2004-11-18) & JP 2004 321898 A (MITSUBISHI RAYON CO., LTD.) 18 November 2004 (2004-11-18)

## Description

### BACKGROUND OF THE INVENTION

### Field of the Invention

The invention relates to a method of producing a photosensitive planographic printing plate precursor. Specifically, the invention relates to a method of producing a photopolymerizable photosensitive planographic printing plate precursor having stable sensitivity and thus being excellent in halftone dot reproducibility, and having excellent developability and excellent stain resistance.

### Description of the Related Art

Conventionally, a photopolymerizable planographic printing plate precursor suitable for AR+laser, YAG-SHG laser, and violet LD laser, and a polymerizable planographic printing plate precursor suitable for infrared laser have been known. They generally include a polymerizable photosensitive layer on a support and may be produced by preparing a liquid of a photosensitive composition containing a compound having an addition polymerizable ethylenic double bond and a polymerization initiator by using an organic solvent, using the liquid as a coating liquid, and applying the liquid to the support (see, for example, Japanese Patent Application Laid-Open (JP-A) Nos. 11-352691, 10-237118, and 2004-117669).

Depending on the environment from the time the liquid is prepared to the time the liquid is applied, in such a coating liquid, polymerization reaction may proceed due to the contained components, making the quality unstable in some cases. Particularly, in recent years, a polymerizable photosensitive layer with higher sensitivity has been required for a planographic printing plate precursor, and along with the higher sensitivity of the photosensitive layer, dark reaction tends to occur in the coating liquid. Therefore, sensitivity, developability, and stain-resistance of printing tend to become uneven. As a result, there is a problem in that halftone dots are thickened due to excessive sensitivity, development failure such as remaining of a film or a color on the printing plate occurs, or a printing is stained.

EP-A-1 564 591 discloses a polymerisable composition suitable for use in the photosensitive layer of a negative lithographic printing plate precursor. The composition comprises a non-acrylic binder polymer, a neutrally charged radical generator and a compound having an ethylenically unsaturated double bond.

EP-A-1 502 735 teaches a lithographic printing plate precursor and a polymerisable composition. The composition comprises a polyurethane compound, a radical initiator and a photo-thermal converting agent.

### SUMMARY OF THE INVENTION

In view of the above circumstances, the invention has been made and provides a method of producing a photosensitive planographic printing plate precursor.

The inventor of the invention made various investigations and consequently focused on controlling the environment from the preparation of a coating liquid containing a photosensitive composition to the application of the liquid, and accordingly has accomplished the invention.

According to the present invention, there is provided a method for producing a photosensitive planographic printing plate precursor comprising:
preparing a coating liquid by dissolving at least a compound having an addition polymerisable ethylenic double bond and a polymerisation initiator in an organic solvent; and
applying the coating liquid on a support,
characterised in that the method further comprises degassing the coating liquid by a degassing apparatus before its application on the support, and the content of dissolved oxygen in the coating liquid from its preparation to the time immediately before degassing by the degassing apparatus is kept at 8.0 mg/l or higher.

The reason for the effect of the invention is uncertain, but the following is presumed.

In the coating liquid of the polymerizable photosensitive composition, the polymerization initiator is decomposed due to heat or change with the lapse of time and the polymerization inhibiting effect is made ineffective because of bonding with dissolved oxygen, and dissolved oxygen is thus decreased. Consequently, due to decomposition of the polymerization initiator caused not only in the coating liquid but also during application and drying of the coating liquid by heat and change with the lapse of time even after a product is produced, dark polymerization reaction is caused and halftone dots are thickened because of excessive sensitivity. At the time of development, film-remnant defects in which the polymerizable photosensitive layer remains without being completely developed at the time of development, and color-remnant defect in which the polymerizable photosensitive layer is adsorbed and remains on the support tend to occur easily, and thus non-image formation parts are easily stained at the time of printing.

### BRIEF DESCRIPTION OF THE DRAWINGS

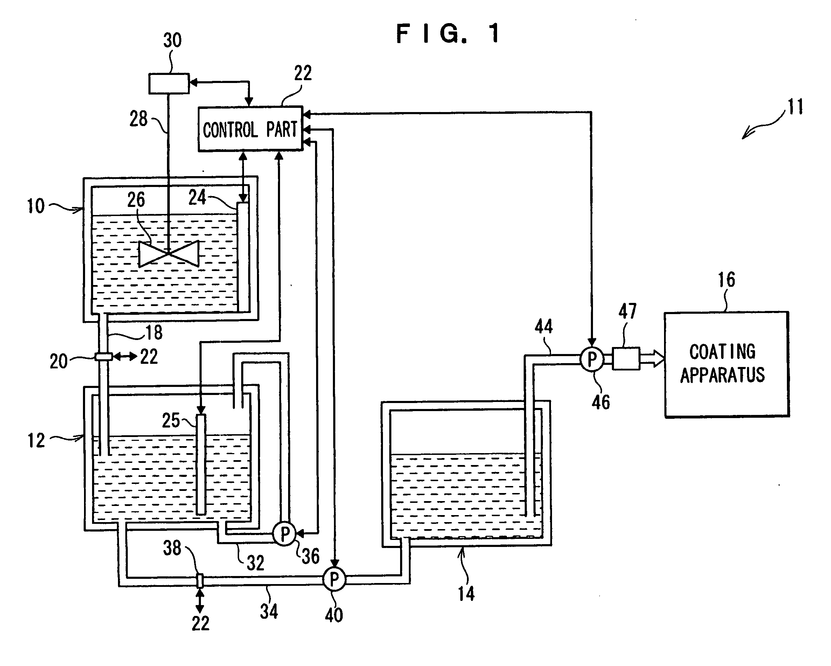

Fig. 1 is a schematic drawing explaining one example of the process from preparing a coating liquid to applying the coating liquid in the invention.

### DETAILED DESCRIPTION OF THE INVENTION

A method of producing a photosensitive planographic printing plate precursor of the invention will be described.

The method of producing a photosensitive planographic printing plate precursor of the invention includes preparing a coating liquid by dissolving at least a compound having an addition polymerizable ethylenic double bond (addition polymerizable compound) and a polymerization initiator in an organic solvent, and applying the coating liquid to a support, and the dissolved oxygen content in the coating liquid from the preparation of the coating liquid to the time immediately before degassing by the degassing apparatus is kept at 8.0 mg/l or higher. In the invention, a degassing apparatus is installed for degassing the coating liquid before application of the coating liquid in order to prevent a foaming and cissing problem due to dissolved oxygen in the coating liquid. The content of dissolved oxygen in the coating liquid is kept at 8.0 mg/l or higher from the time of feeding all of an addition polymerizable compound, a polymerization initiator, and other optional components to an organic solvent and starting stirring of the mixture to the time immediately before the degassing by the degassing apparatus.

In the invention, if the dissolved oxygen content of the coating liquid is lower than 8.0 mg/l, polymerization reaction may proceed and sensitivity may increase to possibly thicken the halftone dots, cause problems of film-remnant defects and color-remnant defects at the time of development, or stain the non-image formation parts at the time of printing. Accordingly, the dissolved oxygen content of the coating liquid is 8.0 mg/l or higher.

Herein, "a coating liquid having a dissolved oxygen content of 8.0 mg/l or higher" means a coating liquid having a dissolved oxygen content of 8.0 mg/l or higher in a case where the dissolved oxygen content is measured by sampling 500 ml of the coating liquid during the time from the preparation of the coating liquid to the application of the coating liquid and carrying out the measurement by a dissolved oxygen measurement apparatus (Portable DO meter DO-21P: manufactured by Toa Denpa Kogyo Co., Ltd.) immediately after the sampling, and specifically means the indicated value after two-minute immersion of a detection part of the above-mentioned dissolved oxygen measurement apparatus in the coating liquid is employed as the dissolved oxygen content.

Examples of methods for controlling the dissolved oxygen content include a method for controlling the time from the preparation of the coating liquid to the application of the coating liquid to a support so as to finish the coating before the dissolved oxygen is decreased to an amount lower than a prescribed amount; a method for supplying oxygen to the coating liquid by stirring the coating liquid (polymerizable photosensitive composition), and a method for supplying oxygen by circulating the coating liquid (polymerizable photosensitive composition) (details will be described later).

Hereinafter, the method of producing a planographic printing plate precursor of the invention will be described in detail with reference to Fig. 1. Fig. 1 is a schematic drawing explaining one example of the process from a step of preparing a coating liquid to a step of applying the coating liquid in the invention. However, the invention is not limited to this example.

As shown in Fig. 1, a coating system 11 includes a liquid preparation tank 10, a stock tank 12, a reservoir 14, a coating apparatus 16, and a control part 22.

The liquid preparation tank 10 stores a coating liquid prepared by dissolving indispensable components (an addition polymerizable compound and a polymerization initiator), and optional components employed based on necessity, in an organic solvent. A variety of raw material tanks (not illustrated) are communicated with the liquid preparation tank 10 through pipes (not illustrated), and the coating system has a structure capable of supplying desired amounts of raw materials to the liquid preparation tank 10 from the raw material tanks through the pipes. The liquid preparation tank 10 is provided with a closable inlet for manually supplying a solid raw material or a raw material whose addition amount is low.

A liquid transportation pipe 18 is formed at the bottom wall of the liquid preparation tank 10 so as to penetrate the outer wall of the liquid preparation tank 10, and the coating liquid stored in the liquid preparation tank 10 is sent to the stock tank 12 through the liquid transportation pipe 18. An opening or closing valve 20 connected to a control part 22 in a signal receivable manner is installed in the liquid transportation pipe 18, so that the communication state of the liquid transportation pipe 18 is made changeable to communication state or non-communication state between the liquid preparation tank 10 and the stock tank 12 by the control part 22, and the liquid supply from the liquid preparation tank 10 to the stock tank 12 is controlled.

A dissolved oxygen meter 24 for measuring the dissolved oxygen content in the coating liquid stored in the liquid preparation tank 10 is installed at the inner wall of the liquid preparation tank 10. Also a propeller type stirring member 26 for stirring the coating liquid stored in the liquid preparation tank 10 is installed in the liquid preparation tank 10 and supported by a motor 30 via a supporting shaft 28.

The dissolved oxygen meter 24 and the motor 30 are connected to the control part 22 in a signal receivable manner.

Also, a temperature adjustment member such as a heater, a cooling apparatus, or the like which is not illustrated is installed in the liquid preparation tank 10. The temperature adjustment member is connected to the control part 22 in a signal receivable manner, so that the temperature of the coating liquid stored in the liquid preparation tank 10 can be adjusted to be a prescribed temperature.

The coating liquid sent from the liquid preparation tank 10 to the stock tank 12 is stored in the stock tank 12. A circulation pipe 32 and a liquid transportation pipe 34 are formed at the bottom wall of the stock tank 12 so as to penetrate the outer wall of the stock tank 12. The circulation pipe 32 is a pipe for circulating the coating liquid stored in the stock tank 12, and one end of the pipe is communicated with the bottom wall of the stock tank 12 and the other end is communicated with the ceiling part of the stock tank 12. Additionally, the end part of the circulation pipe 32 communicated with the ceiling part of the stock tank 12 is formed so as to penetrate the outer wall of the stock tank 12 and so as to be positioned at a prescribed distance or more from the surface of the coating liquid stored in the stock tank 12 . The coating liquid stored in the stock tank 12 is circulated through the circulation pipe 32 by a circulation pump 36 connected to the control part 22 in a signal receivable manner, and turned back to the coating liquid in the stock tank 12 via air existing in the space from the coating liquid surface to the ceiling.

A dissolved oxygen meter 25 for measuring the dissolved oxygen content in the coating liquid stored in the stock tank 12 is installed at the inner wall of the stock tank 12. The dissolved oxygen meter 25 and the circulation pump 36 are connected to the control part in a signal receivable manner.

The stock tank 12 is communicated to the reservoir 14 through the liquid transportation pipe 34. The liquid transportation pipe 34 is equipped with an opening or closing valve 38 for changing the communication state or the non-communication state between the stock tank 12 and the reservoir 14, and a liquid sending pump 40 for sending the coating liquid in the stock tank 12 to the reservoir 14 through the liquid transportation pipe 34.

The opening or closing valve 38 and the liquid sending pump 40 are connected to the control part 22, and the liquid transportation from the stock tank 12 to the reservoir 14 is controlled by the control part 22.

A temperature adjustment member such as a heater, a cooling apparatus, or the like which is not illustrated may also be installed each in the stock tank 12 and the reservoir 14, and each temperature adjustment member may be connected to the control part 22 in a signal receivable manner, so that the temperature of the coating liquid stored in the stock tank 12 and the reservoir 14 may be made adjustable to be a prescribed temperature.

Further, the reservoir 14 is communicated with the coating apparatus 16 through a liquid transportation pipe 44. The liquid transportation pipe 44 is equipped with a liquid sending pump 46 connected to the control part 22 in a signal receivable manner. Further, the liquid transportation pipe 44 is equipped with a degassing apparatus 47.

The coating liquid stored in the reservoir 14 is supplied to the coating apparatus 16 through the liquid transportation pipe 44 by control with the control part 22, and application of the coating liquid to a support is started.

In the invention, the coating liquid prepared in the liquid preparation tank 10 is stored so as to keep the dissolved oxygen content at 8.0 mg/l or higher until the time of starting the application by the coating apparatus 16.

The dissolved oxygen content is kept at 8.0 mg/l or higher from the time of starting the preparation of the coating liquid in the liquid preparation tank 10 to the time of receiving the coating liquid by the degassing apparatus 47 after transportation.

A method for supplying oxygen to the coating liquid by stirring the coating liquid may be a method as follows. That is, for adjusting the dissolved oxygen content of the coating liquid from the preparation of the coating liquid to immediately before degassing the coating liquid, the control part 22 obtains the measurement result of the dissolved oxygen meter 24 at every prescribed period, and determines whether the measurement result is lower than an alarming level which is equal to or higher than 8.0 mg/l the alarming level may be 8.2 mg/l). The motor 30 is controlled by the control part 22 so as to start the stirring of the coating liquid stored in the liquid preparation tank 10 by the stirring member 26 when the result is judged to be lower than the alarming level. Accordingly, the dissolved oxygen content in the coating liquid can be kept at 8.0 mg/l or higher.

In the case where the method of stirring the coating liquid as described above is employed, the dissolved oxygen content can be adjusted without decreasing the dissolved oxygen content in the coating liquid to an amount lower than a prescribed amount. Further, a conventionally employed stirring facility for preparing a coating liquid can be used as the stirring member 26, and the dissolved oxygen content can easily be adjusted with no need of reformation of the facility.

In this connection, in place of the stirring member 26, a bubble generation member for injecting bubbles of air into the coating liquid may be installed in the liquid preparation tank 10.

A method for supplying oxygen by circulating the coating liquid may be a method as follows. That is, for adjusting the dissolved oxygen content of the coating liquid from the preparation of the coating liquid to immediately before degassing the coating liquid, the control part 22 obtains the measurement result of the dissolved oxygen meter 25 at every prescribed period, and determines whether the measurement result is lower than an alarming level which is equal to or higher than 8.0 mg/l (the alarming level may be 8.2 mg/l). The pump 36 is controlled by the control part 22 so as to operate when the result is judged to be lower than the alarming level.

If such control is carried out, the coating liquid stored in the stock tank 12 is circulated through the circulation pipe 32 by the circulation pump 36. When the coating liquid is circulated in such a manner, the coating liquid is foamed and thus the dissolved oxygen content in the coating liquid can be kept at the prescribed amount or higher without decreasing the dissolved oxygen content to an amount lower than the prescribed amount. Also in the method for adjusting the dissolved oxygen content by circulation, the already existing pipe and pump may be employed to actualize the method and thus the dissolved oxygen content can easily be adjusted with no need of large-scale reformation of the facility.

In a case where the time from the preparation of the coating liquid to the application of the coating liquid to a support is controlled, the opening or closing valve 20, the opening or closing valve 38, the liquid sending pump 40, and the liquid sending pump 46 are controlled by the control part 22, so that the time from the preparation of the coating liquid to the application of the coating liquid to a support can be controlled.

Next, the coating liquid to be used in the invention will be described.

The coating liquid to be used in the invention indispensably contains an addition polymerizable compound and a polymerization initiator. Hereinafter, these indispensable components and other optional components will be described in detail. Addition-Polymerizable Compound

The addition-polymerizable compound for use in the invention is an addition-polymerizable compound having at least one ethylenic unsaturated double bond, and is selected from compounds having at least one, and preferably two or more terminal ethylenic unsaturated bonds. These compounds are well known in the art, and any thereof may be used in the invention without restriction. These compounds are present in various chemical forms of monomers, prepolymers such as dimer, trimer and oligomer, and mixtures thereof, and copolymers thereof. Examples of the monomer and copolymer thereof include unsaturated carboxylic acids (e.g., acrylic acid, methacrylic acid, itaconic acid, crotonic acid, isocrotonic acid, and maleic acid) and esters and amides thereof. Preferable examples thereof include esters of unsaturated carboxylic acids and aliphatic polyhydric alcohol compounds, and amides of unsaturated carboxylic acids and aliphatic polyvalent amine compounds. An adduct of an unsaturated carboxylic acid ester or amide having a nucleophilic substituent such as a hydroxyl group, an amino group, or a mercapto group, and a monofuctional or multifunctional isocyanate or an epoxy compound, and/or a dehydration condensation product from a monofuctional or multifunctional carboxylic acid and a monofuctional or multifunctional isocyanate or an epoxy compound is also preferably used. In addition, preferable are an adduct of an unsaturated carboxylic acid ester or amide having an electrophilic substituent such as an isocyanate group, or an epoxy group, and a monofuctional or multifunctional alcohol, amine, or thiol, and/or a substitution product from an unsaturated carboxylic acid ester or amide having a leaving substituent such as a halogen atom, or a tosyloxy group, and a monofuctional or multifunctional alcohol, amine, or thiol. Further, it is possible to use a compound which is obtained in the same manner as those of the above compounds except that the unsaturated carboxylic acid is replaced with an unsaturated phosphonic acid, styrene, or vinyl ether.

Typical examples of the monomers for the esters of an aliphatic polyvalent alcohol compound and an unsaturated carboxylic acid include acrylic esters, methacrylic esters, itaconic esters, crtonic esters, isocrtonic ester and maleic esters. Examples of the acrylic esters include ethylene glycol diacrylate, triethylene glycol diacrylate, 1,3-butanediol diacrylate, tetramethylene glycol diacrylate, propylene glycol diacrylate, neopentyl glycol diacrylate, trimethylol propane triacrylate, trimethylol propane tri(acrlyloyloxypropyl)ether, trimethylol ethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol haxaacrylate, sorbitol triacrylate, sorbitol tetraacrylate, sorbitol pentaacrylate, sorbitol haxaacrylate, tri(acrlyloyloxyethyl)isocyanurate, isocyanuric acid ethylene oxide-modified triacrylate and polyester acrylate oligomers.

Examples of the methacrylic esters include tetramethylene glycol dimethacrylate, triethylene glycol dimethacrylate, neopentyl glycol dimethacrylate, trimethylol propane trimethacrylate, trimethylol ethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis(p-(3-methacryloxy-2-hydroxypropoxy)phenyl)dimethyl methane, and bis-(p-(methacryloxyethoxy)phenyl)dimethyl methane.

Examples of the itaconic esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of the crotonic esters include ethylene glycol dicrotonate, tetramethylene glycol dicrotonate, pentaerythritol dicrotonate, and sorbitol tetradicrotonate.

Examples of the isocrotonic esters include ethylene glycol diisocrotonate, pentaerythritol diisocrotonate, and sorbitol tetraisocrotonate.

Examples of the maleic esters include ethylene glycol dimaleate, triethylene glycol dimaleate, pentaerythritol dimaleate, and sorbitol tetramaleate.

Other examples of the esters include esters derived from aliphatic alcohol described in JP-B No. 51-47334, and JP-A No. 57-196231; compounds having an aromatic skeleton described in JP-A Nos. 59-5240, 59-5241, and 2-226149; and compounds having an amino group described in JP-ANo. 1-165613. Further, the above ester monomers may also be used as a mixture.

Typical examples of the monomers for the amides of an aliphatic polyvalent amine compound and an unsaturated carboxylic acid include methylene bis-acrylamide, methylene bis-methacrylamide, 1,6-hexamethylene bis-acrylamide, 1,6-hexamethylene bis-methacrylamide, diethylenetriamine trisacrylamide, xylylene bisacrylamide, and xylylene bismethacrylamide. Examples of other preferable amide monomers include compounds having a cyclohexylene structure described in JP-B No. 54-21726.

In addition, urethane addition-polymerizable compounds produced in accordance with addition reaction of an isocyanate and a hydroxyl group-containing compound are also preferable, and typical examples thereof include urethane compounds containing two or more polymerizable vinyl groups described in JP-B No. 48-41708, which are prepared by addition-reacting a vinyl monomer containing a hydroxyl group and represented by the following Formula (a) with a polyisocyanate compound having two or more isocyanate groups in the molecule.

CH₂=C(R)COOCH₂CH(R')OH Formula (a)

In the formula, R and R' each independently represent H or CH₃.

Additionally, urethane acrylates described in JP-ANo. 51-37193, and JP-B Nos. 2-32293 and 2-16765; and urethane compounds having an ethylene oxide main chain described in JP-B Nos. 58-49860, 56-17654, 62-39417, and 62-39418 are also preferable. Further, when the addition-polymerizable compounds having an amino structure or a sulfide structure in the molecule and described in JP-ANos. 63-277653, 63-260909, and 1-105238 is contained in a photopolymerizable composition, the composition becomes extremely superior in photosensitization speed.

Other examples thereof include polyester acrylates described in JP-A No. 48-64183, and JP-B Nos. 49-43191 and 52-30490, multifunctional acrylates and methacrylates obtained by reacting an epoxy resin with a (meth)acrylic acid. Still other examples include particular unsaturated compound described in JP-B Nos. 46-43946, 1-40337, and 1-40336, and vinyl phosphonic acid compounds described in JP-A No. 2-25493. In some cases, compounds having a perfluoroalkyl group and described in JP-A No. 61-22048 are preferably used. In addition, a photo-curable monomer or oligomer described in J. Adhesion Soc. Jpn, vol. 20, No. 7, pp. 300 to 308 (1984) may also be used.

The detail of the structure of the addition-polymerizable compound and a method of using the same, for example, the number of types of such compounds used, and the use amount, may be determined arbitrarily according to desired performance of the planographic printing plate precursor finally obtained.

For example, the compounds are selected as follows. The compound preferably has many unsaturated groups per molecule, and thus bivalent or higher-valent compounds are preferable from the viewpoint of sensitivity. In addition, trivalent or higher-valent compounds are preferable to increase strength of image portions, i.e., a cured film. Further, it is effective to use compounds having different valencies and polymerizable groups (e.g., acrylic ester, methacrylic ester, a styrene compound, and/or a vinyl ether compound) to adjust both photosensitivity and strength of the resulting image portions.

Further, compatibility between the addition-polymerizable compound and other components (e.g., a binder polymer, a polymerization initiator, or a coloring agent) and dispersibility thereof in a photosensitive layer are also important factors in selecting or using the addition-polymerizable compound. For example, use of a low-purity compound or a mixture of two or more addition-polymerizable compounds may increase the compatibility.

In addition, a compound having a specific structure may be selected for use in the planographic printing plate precursor for the purpose of increasing adhesiveness between the photosensitive layer, and the support or the protective layer which will be described later.

The content of the addition-polymerizable compound in the photosensitive layer composition is preferably in the range of 20 to 80% and more preferably in the range of 25 to 75% by mass with respect to the total solid contents in the photosensitive layer composition from the viewpoints described above.

One addition-polymerizable compound may be used, or two or more addition-polymerizable compounds may be used together.

### Polymerization Initiator

As a polymerization initiator in the invention, conventionally known polymerization initiators may be used and specific examples include (a) aromatic ketones; (b) onium compounds; (c) organic peroxides; (d) thio compounds; (e) hexaaryl biimidazole compounds; (f) ketoxime ester compounds; (g) borate compounds; (h) azinium compounds; (i) active ester compounds; (j) compounds having a carbon-halogen bond; and (k) metallocene compounds.

Among them (e) hexaaryl biimidazole compounds; (j) compounds having a carbon-halogen bond; (b) onium compounds; and (k) metallocene compounds are preferable and (e) hexaaryl biimidazole compounds are more preferable.

Examples of the (e) hexaaryl biimidazole compounds include lophine dimmers described in Japanese Patent Application Publication (JP-B) Nos.45-37377 and 44-86516 such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, and 2,2'-bis(o-trifluorophenyl)-4,4',5,5'-tetraphenylbiimidazole.

As the (j) compounds having a carbon-halogen bond, trihalomethyl compounds are preferable. The trihalomethyl compounds are preferably trihalomethyl-s-triazines and specific examples include s-triazine derivatives having a trihalogen-substituted methyl group described in JP-A No. 58-29803 such as 2,4,6-tris(trichloromethyl)-s-triazine, 2-methoxy-4,6-bis(trichloromethyl)-s-triazine, 2-amino-4,6-bis(trichloromethyl)-s-triazine, and 2-(p-methoxystyryl)-4,6-bis(trichloromethyl)-s-triazine.

Examples of the (b) onium compounds include onium compounds represented by the following formula (i).

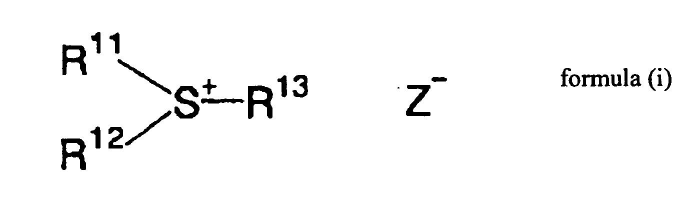

In formula (i), R¹¹, R¹², and R¹³ may be the same or different and each independently represent an hydrocarbon group having 20 or less carbon atoms which may have a substituent. Preferable examples of the substituents include a halogen atom, a nitro group, an alkyl group having 12 or less carbon atoms, an alkoxy group having 12 or less carbon atoms, and an aryloxy group having 12 or less carbon atoms. Z⁻ represents a counter ion selected from the group consisting of a halogen ion, a perchlorate ion, a tetrafluoroborate ion, a hexafluorophosphate ion, a carboxylate ion, and a sulfonic acid ion, and Z⁻ is preferably a perchlorate ion, a hexafluorophosphate ion, a carboxylate ion, or an arylsulfonic acid ion.

Examples of the (k) metallocene compounds include titanocene compounds. As the titanocene compounds, those properly selected from conventionally known compounds such as those described in JP-A Nos. 59-152396 and 61-151197 may be used. Specific examples include di-cyclopentadienyl-Ti-dichloride, di-cyclopentadienyl-Ti-bisphenyl, di-cyclopentadienyl-Ti-bis-2,3,4,5,6-pentafluorophen-1-yl, di-cyclopentadienyl-Ti-bis-2,3,5,6-tetrafluorophen-1-yl, di-cyclopentadienyl-Ti-bis-2,4,6-trifluorophen-1-yl, di-cyclopentadienyl-Ti-bis-2,6-difluorophen-1-yl, di-cyclopentadienyl-Ti-bis-2,4-difluorophen-1-yl, di-methylcyclopentadienyl-Ti-bis-2,3,4,5,6-pentafluorophen-1-yl, di-methylcyclopentadienyl-Ti-bis-2,3,5,6-tetrafluorophen-1-yl, di-methylcyclopentadienyl-Ti-bis-2,4 -difluorophen-1-yl, and bis(cyclopentadienyl)-bis(2,6-difluoro-3-(pyrid-1-ylphenyl) titanium.

These polymerization initiators may be used alone or two or more kinds of them may be used in combination.

The content of the polymerization initiator in the invention may be preferably 0.01 to 1.0% by mass and more preferably 0.05 to 0.5% by mass in the total solid content in the coating liquid. Sensitizing Dye

It is preferable to use a sensitizing dye together with the above-mentioned polymerization initiator in the coating liquid of the invention. The sensitizing dye may properly be selected in accordance with the light source to be employed at the time of exposure of the planographic printing plate precursor to be produced.

At first, a sensitizing dye having an absorption maximum at a wavelength ranging from 300 nm to 500 nm will be described. Examples of the above-mentioned sensitizing dye include merocyanine dyes represented by the following formula (I); benzopyranes and cumarins represented by the following formula (II); aromatic ketones represented by the following formula (III); and anthracenes represented by the following formula (IV).

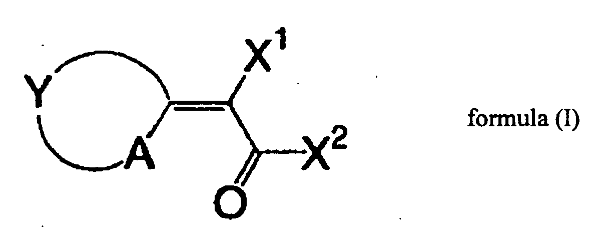

In formula (I), A represents a sulfur atom or NR⁶ and R⁶ represents a monovalent non-metal atomic group; Y represents a non-metal atomic group for forming a basic nucleus of a dye in cooperation with the adjacent A and the adjacent carbon atom; X¹ and X² each independently represent a monovalent non-metal atomic group; and X¹ and X² may bonded to each other to form an acidic nucleus of a dye.

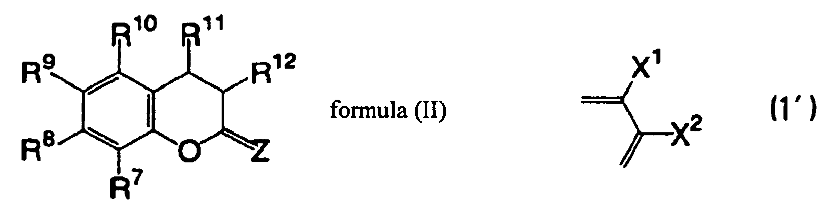

In formula (II), =Z represents a carbonyl, a thiocarbonyl, an imino group, or an alkylidene group represented by partial structural formula (1'); X¹ and X² each are the same as those in formula (I); and R⁷ to R¹² each independently represent a monovalent non-metal atomic group.

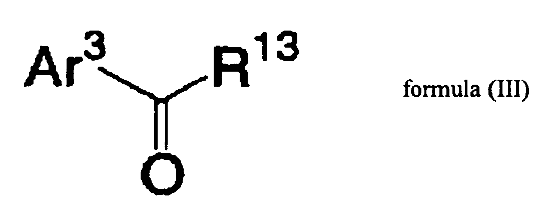

In formula (III), Ar³ represents an aromatic group which may have a substituent or a hetero aromatic group which may have a substituent; and R¹³ represents a monovalent non-metal atomic group. R¹³ preferably represents an aromatic group or a hetero aromatic group and Ar³ and R¹³ may be bonded to each other to form a ring.

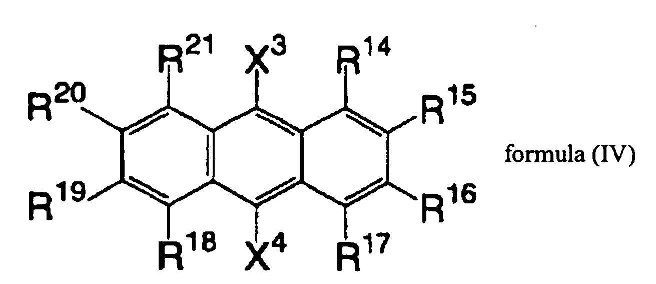

In formula (IV), X³, X⁴, and R¹⁴ to R²¹ each independently represent a monovalent non-metal atomic group. X³ and X⁴ each preferably represent an electron donating group having a negative Hammett's substituent constant.

Preferable examples of the monovalent non-metal atomic group represented by X¹ to X⁴ and R⁶ to R²¹ in formulae (I) to (IV) are a hydrogen atom, an alkyl group (e.g. methyl, ethyl, propyl, butyl pentyl, hexyl, heptyl, octyl, nonyl, decyl, undecyl, dodecyl tridecyl, hexadecyl, octadecyl, eicosyl, isopropyl, isobutyl, sec-butyl, tert-butyl, isopentyl, neopentyl, 1-methylbutyl, isohexyl, 2-ethylhexyl, 2-methylhexyl, cyclohexyl, cyclopentyl, 2-norbornyl, chloromethyl, bromomethyl, 2-chloroethyl, trifluoromethyl, methoxymethyl, methoxyethoxyethyl, allyloxymethyl, phenoxymethyl, methylthiomethyl, tolylthiomethyl, ethylaminoethyl, diethylaminopropyl, morpholinopropyl, acetyloxymethyl, benzoyloxymethyl, N-cyclohexylcarbamoyloxyethyl, N-phenylcarbamoyloxyethyl, acetylaminoethyl, N-methylbenzoylaminopropyl, 2-oxoethyl, 2-oxopropyl, carboxypropyl, methoxycarbonylethyl, allyloxycarbonylbutyl, chlorophenoxycarbonylmethyl, carbamoylmethyl, N-methylcarbamoylethyl, N,N-dipropylcarbamoylmethyl, N-(methoxphenyl)carbamoylethyl, N-methyl-N-(sulfophenyl)carbamoylmethyl, sulfobutyl, sulfonatobutyl, sulfamoylbutyl, N-ethylsulfamoylmethyl, N,N-dipropylsulfamoylpropyl, N-tolylsulfamoylpropyl, N-methyl-N-(phosphonophenyl)sulfamoyloctyl, phosphonobutyl, phosphonatohexyl, diethylphosphonobutyl, diphenylphosphonopropyl, methylphosphonobutyl, methylphosphonatobutyl, tolylphosphonohexyl, tolylphosphonatohexyl, phosphonoxypropyl, phosphonatoxybutyl, benzyl, phenethyl, α-methylbenzyl, 1-methyl-1-phenylethyl, p-methylbenzyl, cinnamyl, allyl, 1-propenylmethyl, 2-butenyl, 2-methylallyl, 2-methylpropenylmethyl, 2-propinyl, 2-butinyl, and 3-butinyl), an aryl group (e.g. phenyl, biphenyl, naphthyl, tolyl, xylyl, mesityl, cumenyl, chlorophenyl, bromophenyl, chloromethylphenyl, hydroxyphenyl, methoxyphenyl, ethoxyphenyl, phenoxyphenyl, acetoxyphenyl, benzoyloxyphenyl, methylthiophenyl, phenylthiophenyl, methylaminophenyl, dimethylaminophenyl, acetylaminophenyl, carboxyphenyl, methoxycarbonylphenyl, ethoxyphenylcarbonyl, phenoxycarbonylphenyl, N-phenylcarbamoylphenyl, phenyl, cyanophenyl, sulfophenyl, sulfonatophenyl, phosphonophenyl, and phosphonatophenyl), a heteroaryl group (e.g. thiophene, thianthrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane, and phenoxazine), an alkenyl group (e.g. vinyl, 1-propenyl, 1-butenyl, cinnamyl, and 2-chloro-1-ethenyl), an alkinyl group (e.g. ethinyl, 1-propinyl, 1-butinyl, and trimethylsilylethinyl), a halogen atom (-F, -Br, -Cl, and -I), a hydroxyl, an alkoxy, an aryloxy, a mercapto, an alkylthio, an arylthio, an alkyldithio, an aryldithio, an amino, an N-alkylamino, an N,N-dialkylamino, an N-arylamino, an N,N-diarylamino, a N,N-diarylamino, an N-alkyl-N-arylamino, an acyloxy, a carbamoyloxy, an N-alkylcarbamoyloxy, an N-arylcarbamoyloxy, a N,N-dialkylcarbamoyloxy, a N,N-diarylcarbamoyloxy, an N-alkyl-N-arylcarbamoyloxy, an alkylsulfoxy, an arylsulfoxy, an acylthio, an acylamino, an N-alkylacylamino, an N-arylacylamino, an ureido, an N'-alkylureido, an N',N'-dialkylureido, an N'-arylureido, an N',N'-diarylureido, an N'-alkyl-N'-arylureido, an N-alkylureido, an N-arylureido, an N'-alkyl-N-alkylureido, an N'-alkyl-N-arylureido, an N',N'-dialkyl-N-alkylureido, an N',N'-dialkyl-N-arylureido, an N'-diaryl-N-alkylureido, an N'-aryl-N-arylureido, an N',N'-diaryl-N-alkylureido, an N',N'-diaryl-N-arylureido, an N'-alkyl-N'-aryl-N-alkylureido, an N'-alkyl-N'-aryl-N-arylureido, an alkoxycarbonylamino, an aryloxycarbonylamino, an N-alkyl-N-alkoxycarbonylamino, an N-alkyl-N-aryloxycarbonylamino, an N-aryl-N-alkoxycarbonylamino, an N-aryl-N-aryloxycarbonylamino, a formyl, an acyl, a carboxyl, an alkoxycarbonyl, an aryloxycarbonyl, a carbamoyl, an N-alkylcarbamoyl, an N,N-dialkylcarbamoyl, an N-arylcarbamoyl, an N,N-diarylcarbamoyl, an N-alkyl-N-arylcarbamoyl, an alkylsulfinyl, an aryl sulfinyl, an alkylsulfonyl, an arylsulfonyl, a sulfo (-SO₃H) and its conjugated basic group (hereinafter, referred to as sulfonato group), an alkoxysulfonyl, an aryloxysulfonyl, a sulfinamoyl, an N-alkylsulfinamoyl, an N,N-dialkylsulfinamoyl, an N-arylsulfinamoyl, an N,N-diarylsulfinamoyl, an N-alkyl-N-arylsulfinamoyl, a sulfamoyl, an N-alkylsulfamoyl, an N,N-dialkylsulfamoyl, an N-arylsulfamoyl, an N,N-diarylsulfamoyl, an N-alkyl-N-arylsulfamoyl, a phosphono (-PO₃H₂) and its conjugated basic group (hereinafter, referred to as phosphonato group), a dialkylphosphono (-PO₃(alkyl)₂), a diarylphosphono (-PO₃(aryl)₂), an alkylarylphosphono (-PO₃(alkyl)(aryl)), a monoalkylphosphono (-PO₃H(alkyl)) and its conjugated basic group (hereinafter, referred to as an alkylphosphonato group), a monoarylphosphono (-PO₃H(aryl) and its conjugated basic group (hereinafter, referred to as an arylphosphonato group), a phosphonoxy (-OPO₃H₂) and its conjugated basic group (hereinafter, referred to as a phosphonatoxy), a dialkylphosphonoxy (-OPO₃(alkyl)₂), a diarylphosphonoxy (-OPO₃(aryl)₂), an alkylarylphosphonoxy (-OPO₃(alkyl)(aryl)), a monoalkylphosphonoxy (-OPO₃H(alkyl)) and its conjugated basic group (hereinafter, referred to as alkylphosphonatoxy group), a monoarylphosphonoxy (-OPO₃H(aryl)) and its conjugated basic group (hereinafter, referred to as arylphosphonatoxy group), a cyano, and a nitro group. Among the above-exemplified substituents, a hydrogen atom, an alkyl group, an aryl group, a halogen atom, an alkoxy group, and an acyl group are preferable.

The basic nucleus of a dye which Y of formula (I) forms in cooperation with the adjacent A and the adjacent carbon atom may be a nitrogen-containing or sulfur-containing 5-, 6-, or 7-membered heterocyclic ring and preferably a 5- or 6-membered heterocyclic ring.

As the above-mentioned nitrogen-containing heterocyclic ring, for example, those of basic nuclei in merocyanine dyes described in L. G. Brooker et al., J. Am. Chem. Soc., 73, 5326-5358 (1951) and the reference documents may be preferably used. Specific examples include thiazoles (e.g. thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenylthiazole), and 4-(2-thienyl)thiazole); benzothiazoles (e.g. benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole, and 5-ethoxycarbonylbenzothiazole); naphthothiazoles (e.g. naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole, and 7-methoxynaphtho[1,2]thiazole); thianaphtheno-7',6',4,5-thiazoles (4'-methoxythianaphtheno-7',6',4,5-thiazole); oxazoles (e.g. 4-methyloxazole, 5-methyloxazole, 4-phenyloxazole, 4,5-diphenyloxazole, 4-ethyloxazole, 4,5-dimethyloxazole, and 5-phenyloxazole); benzoxazoles (benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole, and 6-hydroxybenzoxazole); naphthoxazoles (e.g. naphtho[1,2]oxazole, and naphtho[2,1]oxazole); selenazoles (e.g. 4-methylselenazole, and 4-phenylselenazole); benzoselenazoles (e.g. benzoselenazole, 5-chlorobenzoselenazole, 5-methoxybenzoselenazole, 5-hydroxybenzoselenazole, and tetrahydrobenzoselenazole); naphthoselenazoles (e.g. naphtho[1,2] selenazole, and naphtho[2,1] selenazole); thiazolines (e.g. thiazoline, and 4-methylthiazoline); 2-quinolines (e.g. quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline, and 8-hydroxyquinoline); 4-quinolines (e.g. quinoline, 6-methoxyquinoline, 7-methylquinoline, and 8-methylquinoline); 1-isoquinolines (e.g. isoquinoline and 3,4-dihydroisoquinoline); 3-isoquinolines (e.g. isoquinoline); benzimidazoles (e.g. 1,3-diethylbenzimidazole, and 1-ethyl-3-phenylbenzimidazole); 3,3-dialkylindolenines (e.g. 3,3-dimethylindolenine, 3,3,5-trimethylindolenine, and 3,3,7-trimethylindolenine); 2-pyridines (e.g. pyridine and 5-methylpyridine); and 4-pyridine (e.g. pyridine).

As the above-mentioned sulfur-containing heterocyclic ring, for example, dithiol partial structures of dyes described in JP-A No. 3-296759 may be preferably used. Specific examples include benzodithiols (e.g. benzodithiol, 5-tert-butylbenzodithiol, and 5-methylbenzodithiol); naphthodithiols (e.g. naphtho[1,2]dithiol, and naphtho[2,1]dithiol); and dithiols (e.g. 4,5-dimethyldithiols, 4-phenyldithiols, 4-methoxycarbonyldithiols, 4,5-dimethoxycarbonylbenzodithiols, 4,5-ditrifluoromethyldithiol, 4,5-dicyanodithiol, 4-methoxycarbonylmethyldithiol, and 4-carboxymethyldithiol).

For convenience and convention, the names of the heterocyclic ring mother skeletons are employed in the above description for explaining the heterocyclic rings and in the case of forming a basic skeleton partial structure of a sensitizing dye, it may be introduced in form of an alkylidene-based substituent further decreased by one unsaturation degree just like 3-substituted-2(3H)-benzothiazolylidene group, for example, in a case of a benzothiazole skeleton.

From the viewpoint of high sensitivity, among the sensitizing dyes having an absorption maximum at a wavelength ranging from 360 nm to 450 nm, dyes represented by the following formula (V) are more preferable.

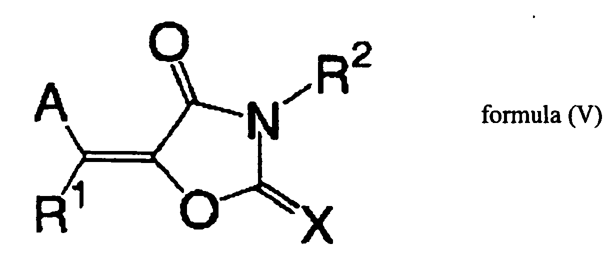

In formula (V), A represents an aromatic ring which may have a substituent or a heterocyclic ring which may have a substituent; X represents an oxygen atom, a sulfur atom, or N-(R³); R¹, R², and R³ each independently represent a hydrogen atom or a monovalent non-metal atomic group; and A and R¹ may be bonded to each other for forming an aliphatic or aromatic ring, and R² and R³ may be bonded to each other for forming an aliphatic or aromatic ring.

Formula (V) will be described more in detail. R¹, R², and R³ each independently represent a hydrogen atom or a monovalent non-metal atomic group and preferably a substituted or unsubstituted alkyl group, a substituted or unsubstituted alkenyl group, a substituted or unsubstituted aryl group, a substituted or unsubstituted aromatic heterocyclic ring residue, a substituted or unsubstituted alkoxy group, a substituted or unsubstituted alkylthio group, a hydroxyl group, or a halogen atom.

Preferable examples of the groups represented by R¹, R², and R³ will be described below. Preferable examples of the alkyl group include linear alkyl groups having 1 to 20 carbon atoms, branched alkyl groups having 1 to 20 carbon atoms and cyclic alkyl groups having 1 to 20 carbon atoms. Specific examples include methyl, ethyl, propyl, butyl, pentyl, hexyl, heptyl, octyl, nonyl, decyl, undecyl, dodecyl, tridecyl, hexadecyl, octadecyl, eicosyl, isopropyl, isobutyl, sec-butyl, tert-butyl, isopentyl, neopentyl, 1-methylbutyl, isohexyl, 2-ethylhexyl, 2-methylhexyl, cyclohexyl, cyclopentyl, and 2-norbomyl groups. Among them linear alkyl groups having 1 to 12 carbon atoms, branched alkyl groups having 3 to 12 carbon atoms, and cyclic alkyl groups having 5 to 10 carbon atoms are preferable.

Preferable examples of heteroaryl groups for R¹, R², and R³ include monocyclic or aromatic polycyclic rings containing at least one of nitrogen, oxygen, and sulfur atoms. Particularly preferable examples of the heteroaryl group include thiophene, thianthrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane, and phenoxazine. These may be further benzo-condensed, and these may further have a substituent.

Preferable examples of an aryl group for R¹, R², and R³ include condensed rings of 1 to 3 benzene rings and condensed rings of a benzene ring and a 5-membered unsaturated ring. Specific examples thereof include phenyl, naphthyl, anthryl, phenanthryl, indenyl, acenaphtenyl, and fluorenyl, and among them phenyl and naphthyl are more preferable.

Next, A in formula (V) will be described. A represents an aromatic ring which may have a substituent or a heterocyclic ring which may have a substituent. Specific examples of the aromatic ring which may have a substituent or the heterocyclic ring which may have a substituent include those described for R¹, R², and R³ in formula (V).

The sensitizing dyes represented by formula (V) can be obtained by condensation reaction of the above-mentioned acidic nucleus or active methylene group-containing acidic nucleus with a substituted or unsubstituted aromatic ring or heterocyclic ring and they may be synthesized with reference to JP-B No. 59-28329.

Specific examples of preferable compounds represented by formula (V) are shown below. With respect to the isomers depending on the double bonds bonding the acidic nucleus and the basic nucleus, any isomer may be used without particular restriction.

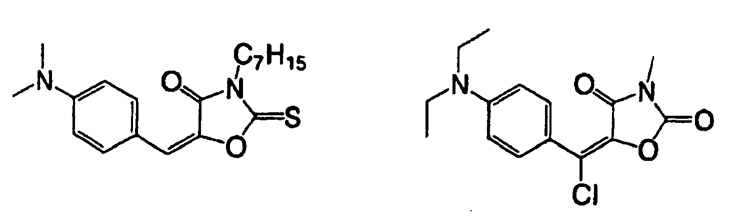

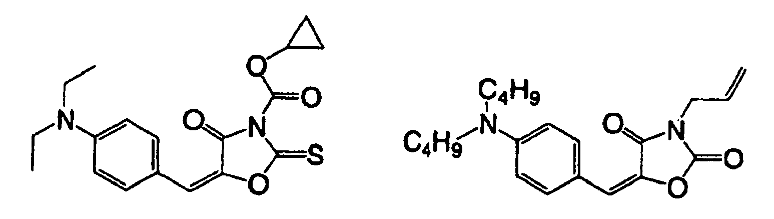

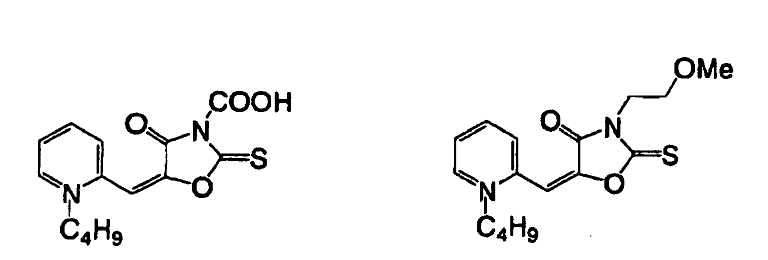

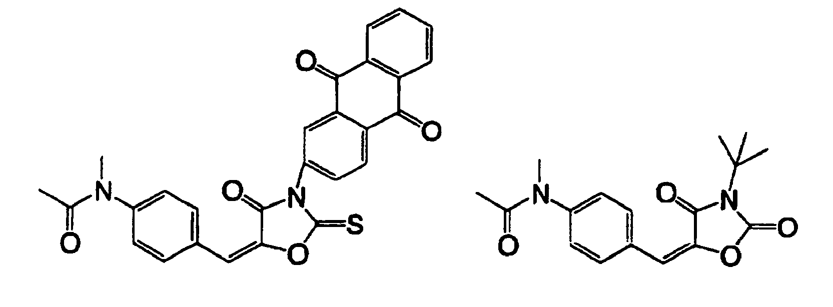

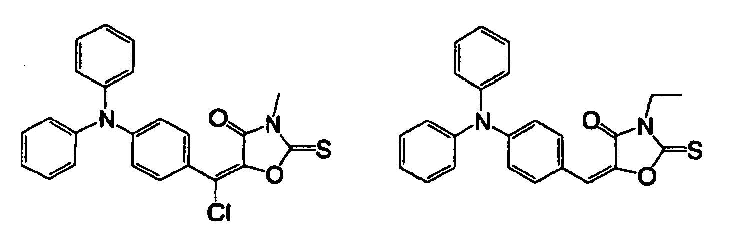

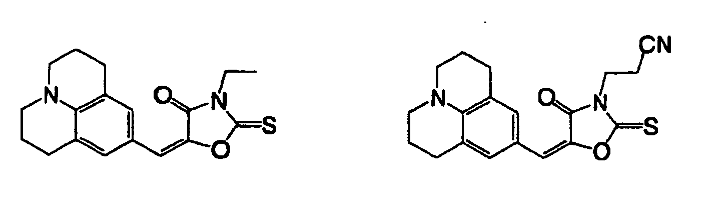

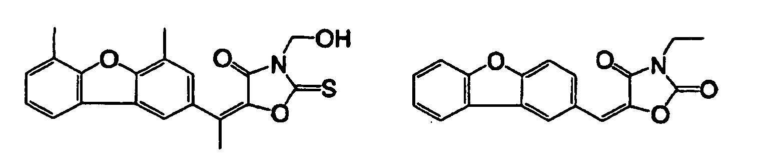

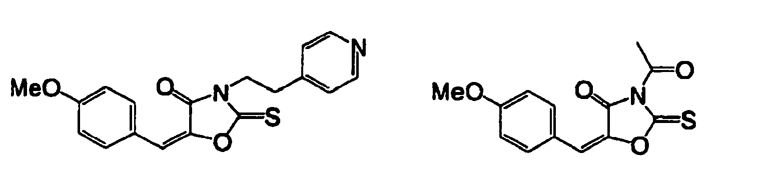

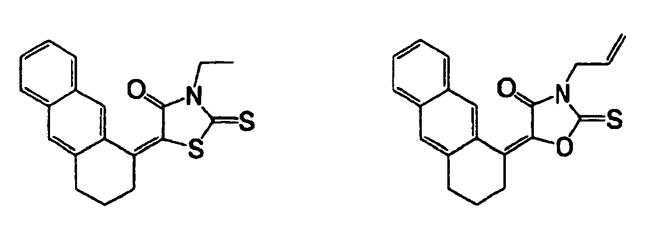

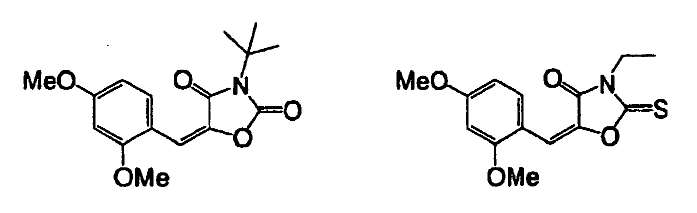

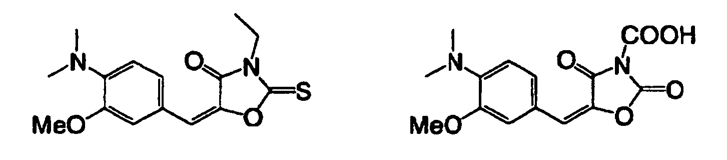

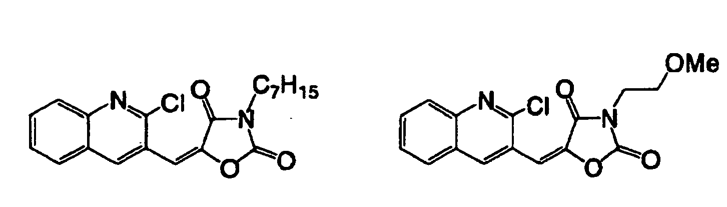

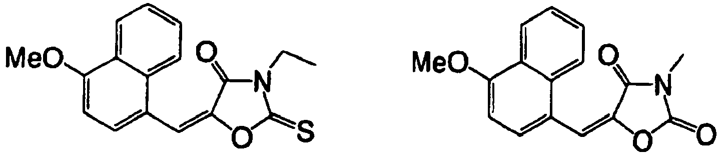

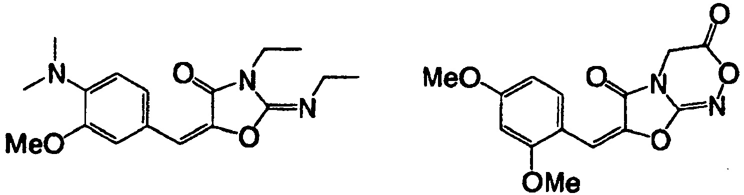

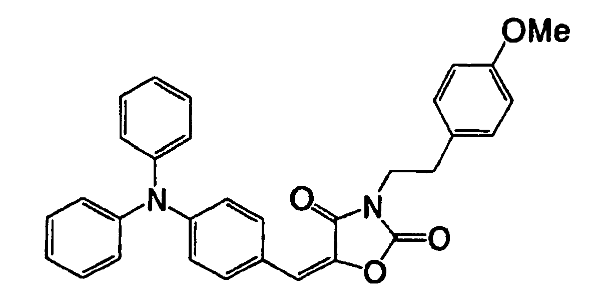

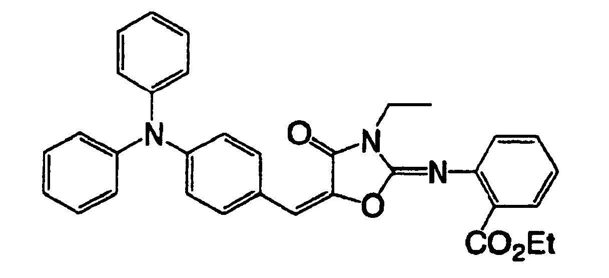

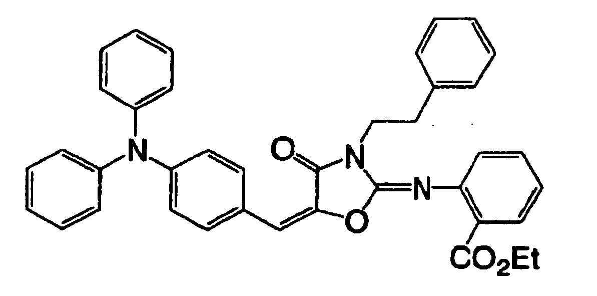

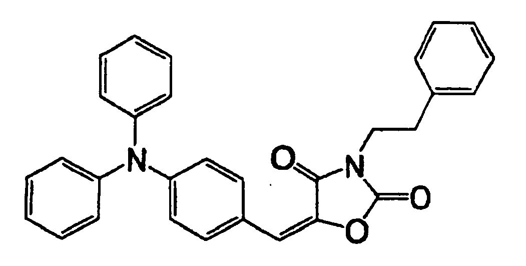

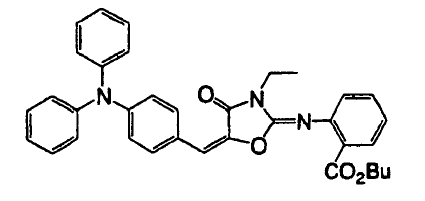

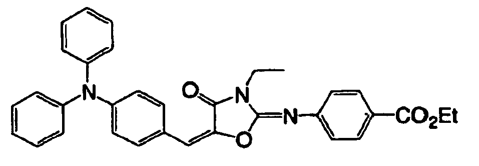

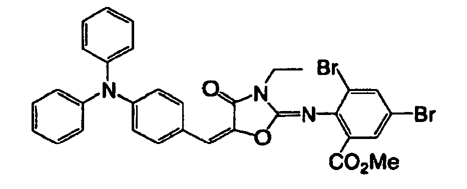

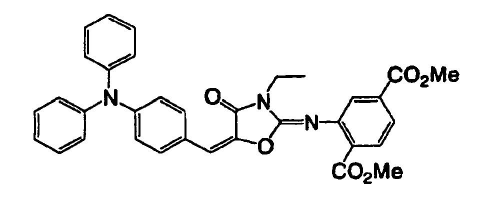

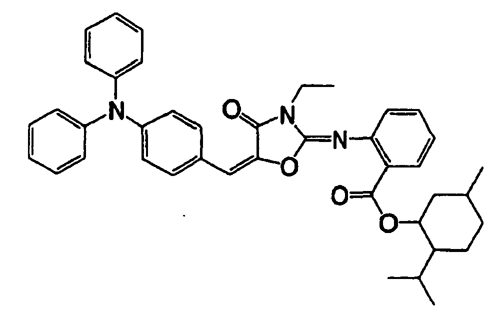

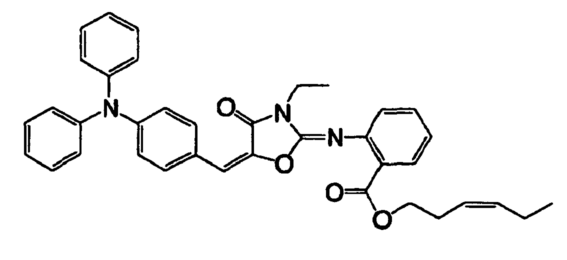

The sensitizing dyes may be preferably used alone or two or more kinds of the sensitizing dyes may be preferably used in combination in the invention.

In general, the amount of the sensitizing dye in the invention is preferably 0.05 to 30 parts by mass, more preferably 0.1 to 20 parts by mass, and even more preferably 0.2 to 10 parts by mass, relative to 100 parts by mass of the total solid content in the coating liquid. Co-initiator

The coating liquid of the invention may contain a co-initiator in order to improve the sensitivity. Examples to be used for the co-initiator include halogenated hydrocarbon compounds (halogenated hydrocarbon derivatives), ketone compounds, ketoxime compounds, organic peroxides, thio compounds, hexaaryl biimidazoles, aromatic onium salts, and oxime ethers.

These co-initiators may be used alone or two or more kinds of them may be used in combination.

The amount of the co-initiator to be used is preferably 0.1 to 50% by mass and more preferably 0.5 to 30% by mass relative to the total solid content of the coating liquid. Polymerization Inhibitor

A small amount of a polymerization inhibitor may be added to the coating liquid of the invention in order to inhibit unnecessary thermal polymerization of the addition polymerizable compound during the preparation of the coating liquid or the storage of the coating liquid.

Examples of polymerization inhibitors which may be preferably used in the invention include hydroquinone, p-methoxyphenol, di-tert-butyl-p-cresol, pyrogallol, tert-butylcatechol, benzoquinone, 4,4'-thiobis(3-methyl-6-tert-buylphenol), 2,2'-methylenebis(4-methyl-6-tert-butylphenol), N-nitrosophenylhydroxyamine aluminum salt, N-nitrosophenylhydroxyamine cerium (III) salt.

These polymerization inhibitors may be used alone or two or more kinds of them may be used in combination.

The unnecessary thermal polymerization of the addition polymerizable compound can be inhibited by dissolved oxygen and the polymerization inhibitor in the coating liquid. Therefore, unnecessary thermal polymerization can be prevented during the time from the preparation of the coating liquid to the application of the coating liquid to the support by adjusting the amount of the dissolved oxygen and the amount of the polymerization inhibitor in good balance in the coating liquid.

In the invention, the addition amount of the polymerization initiator is preferably about 0.01% by mass to about 5% by mass relative to the total solid content of the coating liquid. Binder Polymer

It is preferable to add a binder polymer to the coating liquid of the invention to improve the film property of the photosensitive layer.

As the binder polymer, conventionally known binders can be used without limitation and linear organic polymers having film formability are preferable. Examples such binder polymers include acrylic resins, polyvinyl acetal resins, polyurethane resins, polyurea resins polyimide resins, polyamide resins, epoxy resins, methacrylic resins, polystyrene resins, novolak-based phenyl resins, polyester resins, synthetic rubber, and natural rubber.

The binder polymer preferably has cross-linking capability in order to improve the coating strength of image parts. To provide the binder polymer with the cross-linking capability, a cross-linking functional group such as ethylenic unsaturated bond may be introduced into the main chain or side chains of the polymer. The cross-linking functional group may be introduced by copolymerization or by polymer reaction.

Herein, the cross-linking group is a group for cross-linking the binder polymer during the radical polymerization reaction caused in the photosensitive layer when the planographic printing plate precursor is exposed. Any group having such function can be used without limitation and examples of functional groups reactive in the addition polymerization reaction include an ethylenic unsaturated bond group, an amino group, and an epoxy group. The cross-linking group may be a functional group to be radical by light radiation and examples of such cross-linking groups include a thiol group, a halogen group, and an onium salt structure. Among them, the ethylenic unsaturated bond group is preferable and functional groups represented by the following formulae (1) to (3) are particularly preferable.

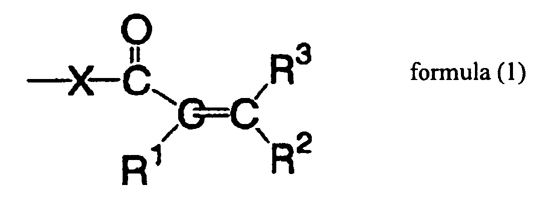

In formula (1), R¹ to R³ each independently represent a monovalent organic group.

R¹ is preferably a hydrogen atom, an alkyl group which may have a substituent, or the like. Among them, R¹ is more preferably a hydrogen atom or a methyl group, due to high radical reactivity.

R² and R³ each independently represent a hydrogen atom, a halogen atom, an amino group, a carboxyl group, an alkoxycarbonyl group, a sulfo group, a nitro group, a cyano group, an alkyl group which may have a substituted, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or arylsulfonyl group which may have a substituent. Among them, a hydrogen atom, a carboxyl group, an alkoxycarbonyl group, an alkyl group which may have a substituent, and aryl group which may have a substituent are particularly preferable due to high radical reactivity.

X represents an oxygen atom, a sulfur atom, or -N(R¹²)-, and R¹² represents a hydrogen atom or a monovalent organic group. Herein, R¹² may be, for example, an alkyl group which may have a substituent, or the like, and particularly preferably a hydrogen atom, a methyl group, an ethyl group, or an isopropyl group due to high radical reactivity.

Herein, examples of the substituent to be introduced into include an alkyl group, an alkenyl group, an alkinyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group, and an arylsulfonyl group.

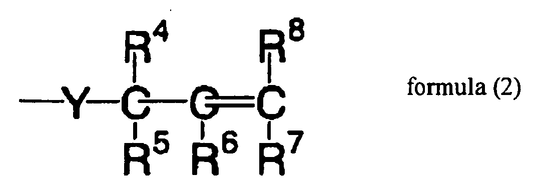

In the above-mentioned formula (2), R⁴ to R⁸ each independently represent a monovalent organic group. R⁴ to R⁸ each preferably represent a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy gruop which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and among them, a hydrogen atom, a carboxyl group, an alkoxycarbonyl group, an alkyl group which may have a substituent, and aryl group which may have a substituent are particularly preferable due to high radical reactivity.

The substituent to be introduced thereinto may be same as those exemplified in formula (1). Y represents an oxygen atom, a sulfur atom, or -N(R¹²)-, and R¹² represents the same as described for R¹² in formula (1) and preferable examples are also same.

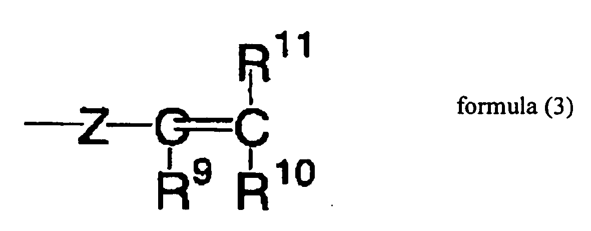

In the above-mentioned formula (3), R⁹ preferably represents a hydrogen atom, or an alkyl group which may have a substituent, or the like, and more preferably a hydrogen atom and a methyl due to high radical reactivity. R¹⁰ and R¹¹ each independently represent a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and among them, a hydrogen atom, a carboxyl group, an alkoxycarbonyl group, an alkyl group which may have a substituent, and an aryl group which may have a substituent are preferable due to high radical reactivity.

The substituent to be introduced into may be same as those exemplified in formula (1). Z represents an oxygen atom, a sulfur atom, and -N(R¹³)- or a phenylene group which may have a substituent. R¹³ represents, for example, an alkyl group which may have a substituent or the like, and preferably a methyl group, an ethyl group, or an isopropyl group due to high radical reactivity.

Since the binder polymer having the above-mentioned cross-linking group in the side chains of the invention preferably has a function as a coating forming agent for the photosensitive layer and is preferably soluble in a developer, preferably an alkaline developer, the binder polymer is preferably an organic high molecular weight polymer which is soluble in an alkaline water or has swelling property. Therefore, the binder polymer of the invention preferably has an alkali-soluble group, e.g. a carboxyl group, other than the cross-linking group in the side chains.

In the case where the binder polymer has the cross-linking group in the side chains is a water-soluble organic high molecular weight polymer, development with water is made possible.

Examples of the binder polymer in the invention include those described in JP-A Nos. 59-53836 and 59-71048, such as (meth)acrylic acid copolymers having a cross-linking group such as an allyl group, a (meth)acryloyl group or the like in the side chains, itaconic acid copolymers having a cross-linking group such as an allyl group, a (meth)acryloyl group or the like in side chains, crotonic acid copolymers having a cross-linking group such as an allyl group, a (meth)acryloyl group or the like in the side chains, maleic acid copolymers having a cross-linking group such as an allyl group, a (meth)acryloyl group or the like in the side chains, and partially esterified maleic acid copolymers having a cross-linking group such as an allyl group, a (meth)acryloyl group or the like in the side chains.

Examples of the binder polymer in the invention further include polyurethanes having the above-mentioned cross-linking group and a carboxyl group in the side chains, cellulose derivatives having the above-mentioned cross-linking group and a carboxyl group, and compounds having the above-mentioned cross-linking group obtained by adding cyclic acid anhydrides to an addition polymer having a hydroxyl are preferable.

Among them, (meth)acrylic acid copolymers and polyurethanes are more preferable. Particularly, polyurethane resins are preferable since they can suppress development damages of the exposed parts and provide good stain resistance without decreasing the developability of non-exposure parts even if the acid value of the photosensitive layer is low.

Hereinafter, the polyurethane resins having a cross-linking group in the side chains will be described more in detail.

The polyurethane resins having a cross-linking group in the side chains which may be preferably used in the invention are produced by addition polymerization reaction of (i) a diisocyanate compound, (ii) a diol compound having a carboxyl group, (iii) a diisocyanate compound having a cross-linking group, and if necessary (iv) a diol compound having no carboxyl group.

Hereinafter, the diisocyanate compound and the diol compound, which are raw materials for the polyurethane resins will be described.

### (i) Diisocyanate compound

Examples of the diisocyanate compound include diisocyanate compounds represented by the following formula (4).

OCN-L-NCO (4)

In formula (4), L represents a divalent aliphatic or aromatic hydrocarbon group which may have a substituent. If necessary, the groups represented by L may have other functional groups not reactive with an isocyanate group, such as a carbonyl group, an ester group, an urethane group, an amido group, and an ureido group. More specifically, L represents a single bond or a divalent aliphatic or aromatic hydrocarbon group which may have a substituent (for example, an alkyl group, an aralkyl group, an aryl group, an alkoxy group, and a halogeno group). L represents preferably an alkylene group having 1 to 20 carbon atoms and an arylene group having 6 to 15 carbon atoms; and more preferably an alkylene group having 1 to 8 carbon atoms. If necessary, the groups represented by L may have other functional groups not reactive with an isocyanate group, such as a carbonyl group, an ester group, an urethane group, an amido group, an ureido group, and an ether group.

Specific examples include aromatic diisocyanate compounds such as 2,4-tolylene diisocyanate, 2,4-tolylene diisocyanate dimer, 2,6-tolylene diisocyanate, p-xylylene diisocyanate, m-xylylene diisocyanate, 4,4'-diphenylmethane diisocyanate, 1,5-naphthylene diisocyanate, and 3,3'-diemethylbiphenyl-4,4'-diisocyanate; aliphatic diisocyanate compounds such as hexamethylene diisocyanate, trimethylhexamethylene diisocyanate, lysine diisocyanate, and dimmer acid diisocyanate; alicyclic diisocyanate compounds such as isophorone diisocyanate, 4,4'-methylenebis(cyclohexyl isocyanate), methylcyclohexane-2,4 (or 2,6)-diisocyanate, and 1,3-(isocyanatomethyl)cyclohexane; and diisocyanate compounds which are reaction products of diols and diisocyanates such as adducts of 1 mole of 1,3-butylene glycol and 2 mole of tolylene diisocyanate.

The diisocyanate compounds may be used alone or two or more kinds may be used in combination. From the viewpoint of stain resistance, two or more kinds of the diisocyanate compounds are preferably used in combination, and it is particularly preferable to use each one kind of aromatic diisocyanate compounds (L is an aromatic group) and aliphatic diisocyanate compounds (L is an aliphatic group) in combination.

The amount of the diisocyanate compound to be used is preferably 0.8 to 1.2 and more preferably 0.9 to 1.1 by mole ratio relative to the diol compound. In the case the diisocyanate compound is used in an excessive amount to the diol compound, and isocyanate group remains in the polymer terminals, it is preferable to treat the product obtained after polyurethane reaction with an alcohol or amine so as to carry out synthesis of the final product without a remaining diisocyanate group.

### (ii) Diol compound having at least one carboxyl group

Examples of the diol compound having at least one carboxyl group include diol compounds represented by the following formulae (5), (6), and (7) and/or compounds obtained ring-opening reaction of tetracarboxylic acid dianhydrides with diol compounds. Diol compounds to be used for ring-opening reaction of carboxylic acid dianhydrides may also be used as the diol compounds having at least one carboxylic group.

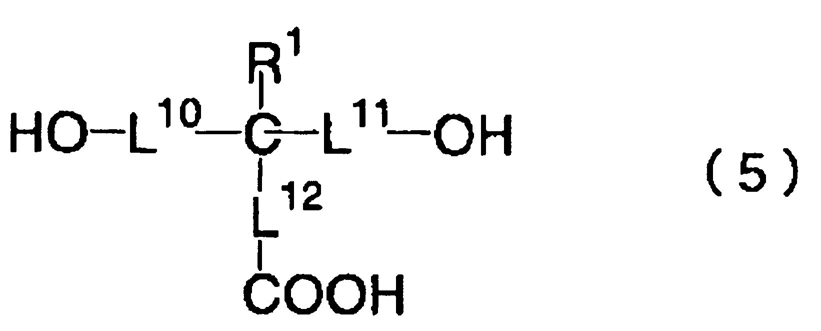

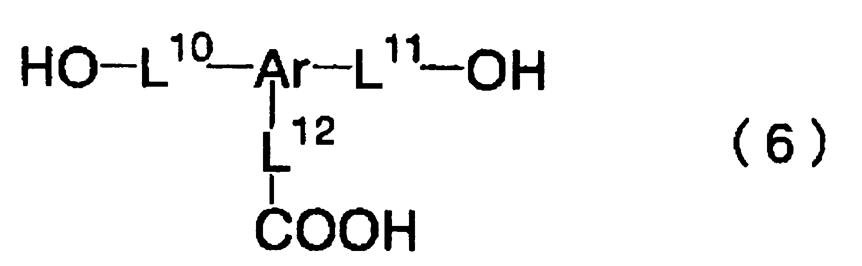

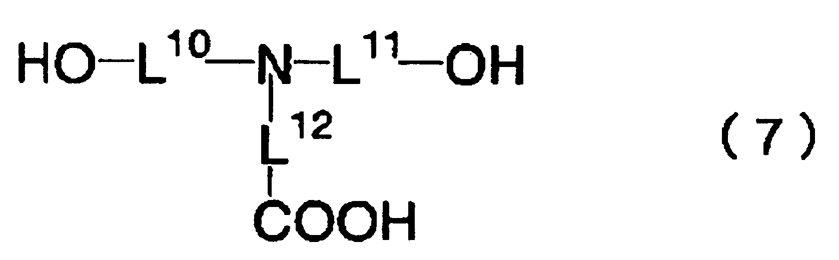

In the formulae, R¹ represents a hydrogen atom or an alkyl, aralkyl, aryl, alkoxy, or aryloxy group which may have a substituent (examples of the substituent include a cyano group, a nitro group, a halogen (-F, -Cl, -Br, and -I), -CONH₂, -COOR¹¹³, -OR¹¹³, -NHCONHR¹¹³, -NHCOOR¹¹³, -NHCOR¹¹³, -OCONHR¹¹³ (wherein R¹¹³ represents an alkyl group having 1 to 10 carbon atoms or an aralkyl group having 7 to 15 carbon atoms)), and preferably represents a hydrogen atom, an alkyl group having 1 to 8 carbon atoms, or an aryl group having 6 to 15 carbon atoms. L¹⁰, L¹¹, and L¹² may be the same or different one another and independently represent a single bond or a divalent aliphatic or aromatic hydrocarbon group which may have a substituent (preferable examples of the substituents include an alkyl group, an aralkyl group, an aryl group, an alkoxy group, and a halogeno groups); preferably represent an alkylene group having 1 to 20 carbon atoms or an arylene group having 6 to 15 carbon atoms; and more preferably represents an alkylene group having 1 to 8 carbon atoms. Further, if necessary, the groups represented by L¹⁰, L¹¹, and L¹² may have other functional groups not reactive with an isocyanate group, such as carbonyl, ester, urethane, amido, and ureido. Additionally, two or three among R¹, L¹⁰, L¹¹, and L¹² may form a ring. Ar represents ad trivalent aromatic hydrocarbon group which may have a substituent and preferably represents an aromatic group having 6 to 15 carbon atoms.

Specific examples of the carboxyl-containing diol compounds represented by formulae (5), (6), and (7) include following compounds,

That is, 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl)acetic acid, 2,2-bis(hydroxyphenyl)butyric acid, 4,4-bis(4-hydroxyphenyl)pentanoic acid, tartaric acid, N,N-dihydroxyethylglycine, and N,N-bis(2-hydroxyethyl)-3-carboxy-propionamide.

Further, examples of the tetracarboxylic acid dianhydride preferably used in production of at least one kind of diol compounds having at least one carboxyl group include those represented by the following formulae (8), (9), and (10).

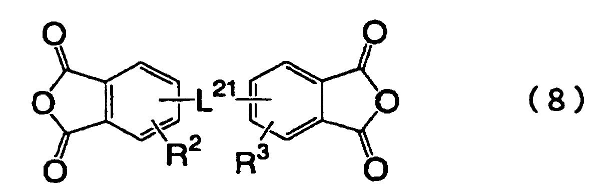

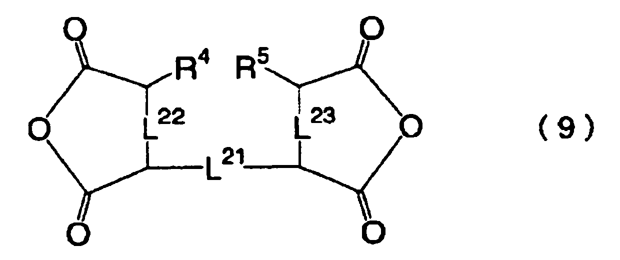

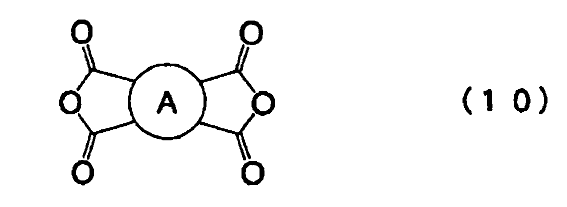

In the formulae, L²¹ represents a single bond, a divalent aliphatic or aromatic hydrocarbon group which may have a substituent (preferable examples of the substituents include an alkyl group, an aralkyl group, an aryl group, an alkoxy group, a halogeno group, an ester group, an amide group), -CO-, -SO-, -SO₂-, -O-, or -S-; and preferably represents a single bond, a divalent aliphatic hydrocarbon group having 1 to 15 carbon atoms, -CO-, -SO₂-, -O-, or -S-. R² and R³ may be the same or different and each independently represent a hydrogen atom, an alkyl, an aralkyl, an aryl, an alkoxy, or a halogeno group and preferably represent a hydrogen atom, an alkyl group having 1 to 8 carbon atoms, an aryl group having 6 to 15 carbon atoms, an alkoxy group having 1 to 8 carbon atoms, or a halogeno group. Two of L²¹, R², and R³ may be bonded with each other to form a ring. R⁴ and R⁵ may be the same or different and each independently represent a hydrogen atom, an alkyl group, an aralkyl group, an aryl group, or a halogeno group, and preferably represent a hydrogen atom, an alkyl group having 1 to 8 carbon atoms, or an aryl group having 6 to 15 carbon atoms. Two of L²¹, R⁴, and R⁵ may be bonded with each other to form a ring. L²² and L²³ may be same or different and independently represent a single bond, a double bond, or a divalent aliphatic hydrocarbon group, and preferably represent a single bond, a double bond or a methylene group. A represents a single nucleus or polynucleus aromatic ring, and preferably represents an aromatic ring having 6 to 18 carbon atoms.

Specific examples of the compounds represented by formulae (8), (9), and (10) include the following compounds.

That is, aromatic tetracarboxylic acid dianhydride such as pyromellitic acid dianhydride, 3,3',4,4'-benzophenonetetracarboxylic acid dianhydride, 3,3',4,4'-diphenyltetracarboxylic acid dianhydride, 2,3,6,7-naphthalenetetracarboxylic acid dianhydride, 1,4,5,8-naphthalenetetracarboxylic acid dianhydride, 4,4'-sulfonyldiphthalic acid dianhydride, 2,2-bis(3,4-dicarboxyphenyl)propane dianhydride, bis(3,4-dicarboxyphenyl) ether dianhydride, 4,4'-[3,3'-(alkylphosphoryldiphenylene)-bis(iminocarbonyl)]diphthalic acid dianhydride, adduct of hydroquinone diacetate and trimellitic acid anhydride, and adduct of diacetyldiamine and trimellitic acid anhydride; alicyclic tetracarboxylic acid dianhydride such as 5-(2,5-dioxotetrahydrofuryl)-3-methyl-3-cyclohexene-1,2-dicarboxylic acid anhydride (EPICLON B-4400, manufactured by Dainippon Ink and Chemicals, Inc.), 1,2,3,4-cyclopentanetetracarboxylic acid dianhydride, 1,2,4,5-cyclopentanetetracarboxylic acid dianhydride, and tetrahydrofurancarboxylic acid dianhydride; and aliphatic tetracarboxylic acid dianhydride such as 1,2,3,4-butanetetracarboxylic acid dianhydride, and 1,2,4,5-pentatetracarboxylic acid dianhydride.

(ii) At least one kind of the diol compounds having at least one carboxyl can be synthesized by ring-opening these tetracarboxylic acid dianhydride with diol compounds. However, it is also possible to synthesize polyurethane resin of the invention by at first carrying out reaction of a diol compound and (i) a diisocyanate compound and successively carrying out reaction of the reaction product and a tetracarboxylic acid dianhydride exemplified above and this method also within a scope of the invention. That is, there are the following methods of introducing a structure unit derived from a tetracarboxylic acid dianhydride and a diol compound into a polyurethane resin:
a) a method of causing a reaction of a compound having alcohol terminal, which is obtained by ring-opening a tetracarboxylic acid dianhydride with a diol compound, and a diisocyanate compound: and
b) a method of causing a reaction of an urethane compound having alcohol terminal, which is obtained by reaction of a diisocyanate compound and an excessive amount of a diol compound, and a tetracarboxylic acid dianhydride.

A compound represented by formula (5) is more preferable among the above-mentioned diol compounds having at least one carboxyl group since it has a high solvent-solubility and is easy to be synthesized.

The diol compounds having at least one carboxyl group are introduced into the polyurethane resin binder in an amount to satisfy the ratio of carboxyl group per 1 g of polyurethane reins binder in a range of 0.2 to 4.0 meq/g, preferably 0.3 to 3.0 meq/g, more preferably 0.4 to 2.0 meq/g, furthermore preferably 0.5 to 1.5 meq/g, and even more preferably 0.6 to 1.2 meq/g. Accordingly, although it depends on the number of carboxyl groups, what kind diol is used as other diol components, the acid value and molecular weight of the polyurethane resin binder to be obtained, the composition and the pH of a developer, the content of the structure derived from at least one kind of diol compounds having at least one carboxyl group in the polyurethane resin binder is in a range of 5 to 45% by mole, preferably 10 to 40% by mole, and even more preferably 15 to 35% by mole.

### (iii) Diisocyanate compound having a cross-linking group

Examples of the diisocyanate compound having a cross-linking group include a product obtained by addition reaction of a triisocyanate compound with an equimolecular amount of a monofunctional alcohol or amine compound having cross-linking group.

Specific examples of the triisocyanate compound include the following compounds, however it should not be limited to these compounds.

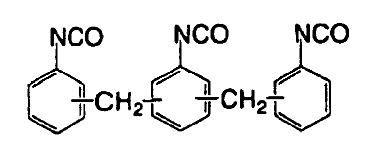

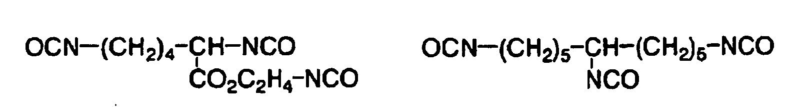

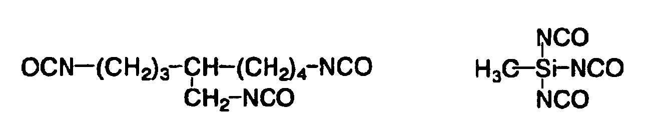

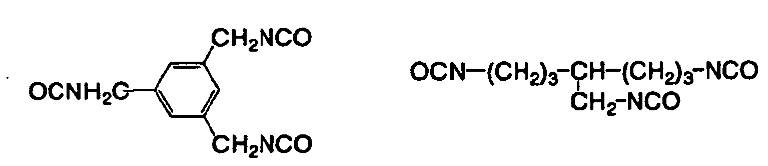

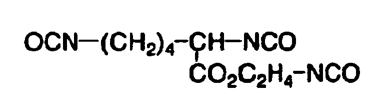

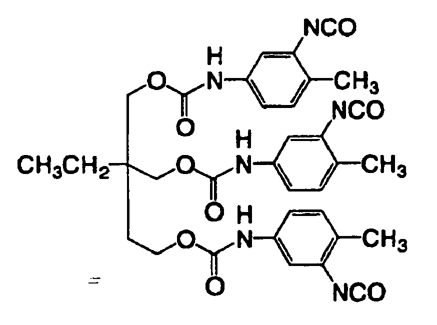

Examples of the monofunctional alcohol or amine compound having a cross-linking group include the following compounds, however it should not be limited to these compounds.

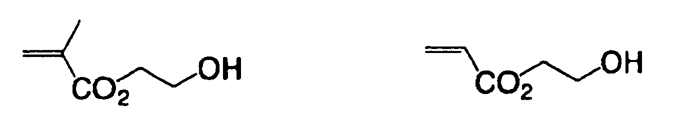

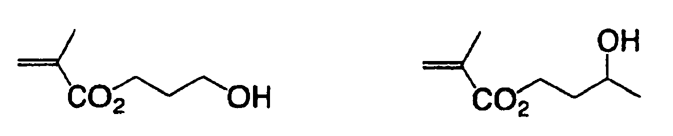

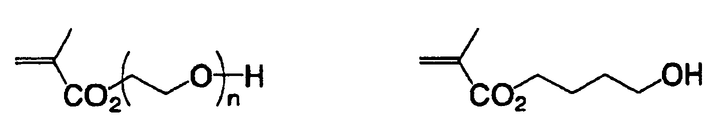

n represents an integer from 2 to 10

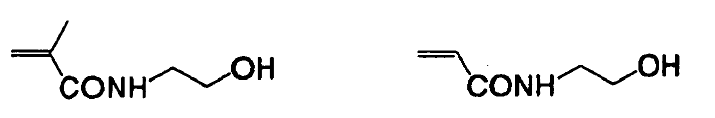

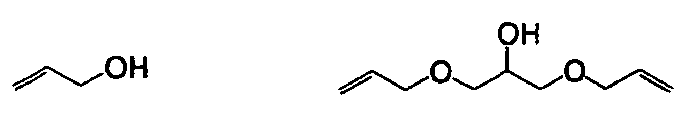

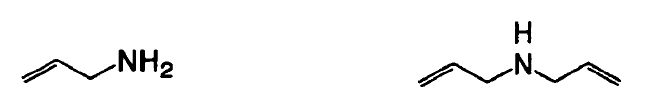

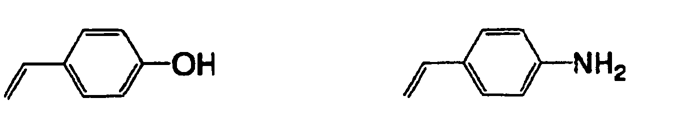

Herein, a method of introducing the cross-linking group into the side chains of the polyurethane resin is preferably a method of using a diisocyanate compound having a cross-linking group in the side chain as a raw material for polyurethane resin production. Examples of the diisocyanate compound having a cross-linking group in the side chain obtained by addition reaction of a triisocyanate compound with an equimolecular amount of a monofunctional alcohol or amine compound having a cross-linking group include the following compounds, however it should not be limited to these compounds.

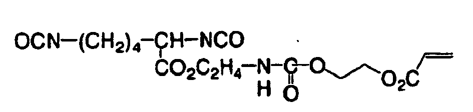

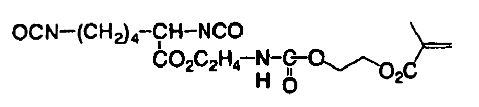

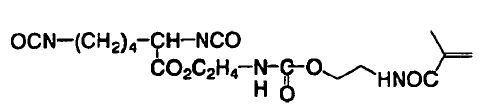

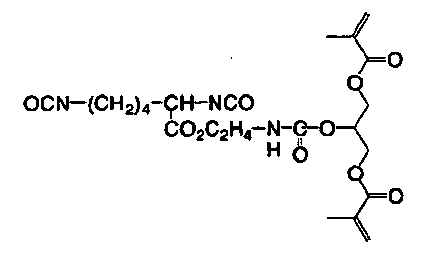

### (iv) Other diol compounds

Beside the above-mentioned methods, a method of using a diol compound having an unsaturated group in the side chain as a raw material of the polyurethane resin production is also preferable for the method of introducing the unsaturated group into the side chains of the polyurethane resin. Examples of such diol compounds include commercially available ones such as trimethylolpropane monoallyl ether and compounds easily produced by reaction of a halogenated diol compound, triol compound, or aminodiol compound with a carboxylic acid having an unsaturated group, an acid chloride, an isocyanate, an alcohol, an amine, a thiol, or an alkyl halide. Specific examples of these diol compounds include the following compounds, however they should not be limited to them.

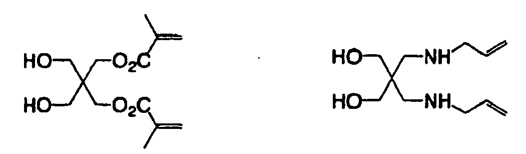

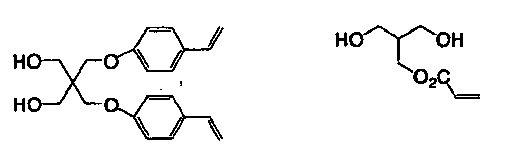

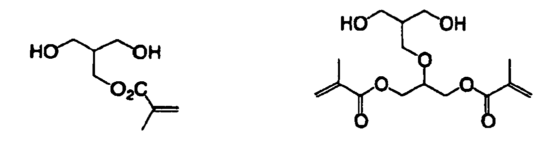

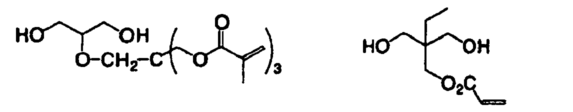

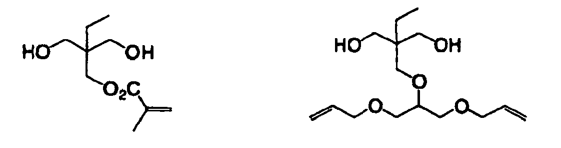

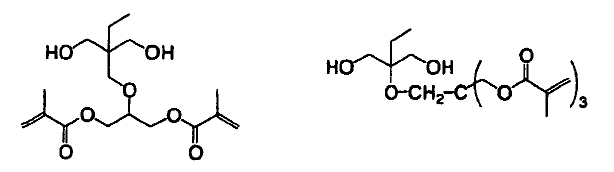

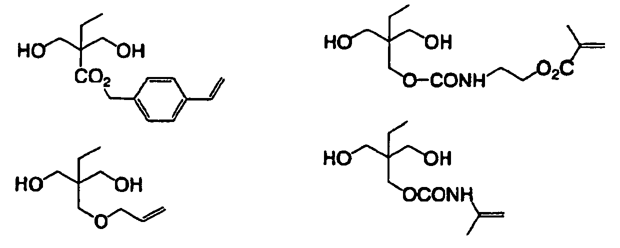

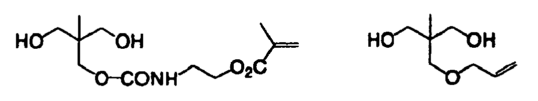

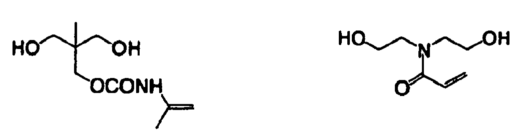

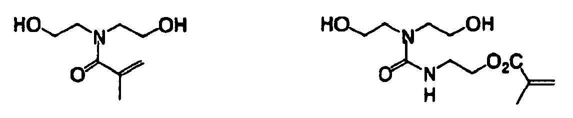

Further, as other diol compounds, ethylene glycol compounds represented by the following formula (A') may be used.

HO-(CH₂CH₂O)ₙ-H (A')

In formula (A'), n represents an integer of 1 or higher.

As other diol compounds, random copolymers and block copolymers of ethylene oxide and propylene oxide having hydroxyl at terminals may also be used.

Further, ethylene oxide adducts of bisphenol A (the addition number of ethylene oxide is from 27 to 100), ethylene oxide adducts of bisphenol F (the addition number of ethylene oxide is from 22 to 100), ethylene oxide adducts of hydrogenated bisphenol A (the addition number of ethylene oxide is from 23 to 100), and ethylene oxide adducts of hydrogenated bisphenol F (the addition number of ethylene oxide is from 18 to 100) may also be used. More specifically, ethylene glycol compounds represented by formula (A') are preferable from the viewpoint of the stain resistance and ethylene glycol compounds with n in a range of 2 to 50 are preferable, ethylene glycol compounds with n in a range of 3 to 30 are more preferable, and ethylene glycol compounds with n in a range of 4 to 10 is even more preferable.

Diol compounds represented by the following formula (16), (17), or (18) may be preferably used.

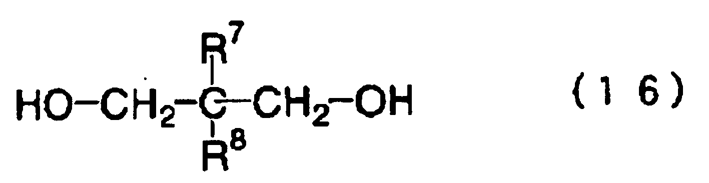

HO-CH₂-C≡C-CH₂-OH (17)

HO-CH₂-CH=CH-CH₂-OH (18)

In the formula, R⁷ and R⁸ may be the same or different and each independently represent an alkyl group which may have a substituent, and preferably an alkyl group having 1 to 10 carbon atoms which may have a substituent such as a cyano group, a nitro group, a halogen atom (-F, -Cl, -Br, -I), -CONH₂-, -COOR, -OR (wherein, R may be the same or different and represents an alkyl group having 1 to 10 carbon atoms, an aryl group having 7 to 15 carbon atoms, and an aralkyl group).

Specific examples of the diol compounds represented by formula (16) include the following compound.

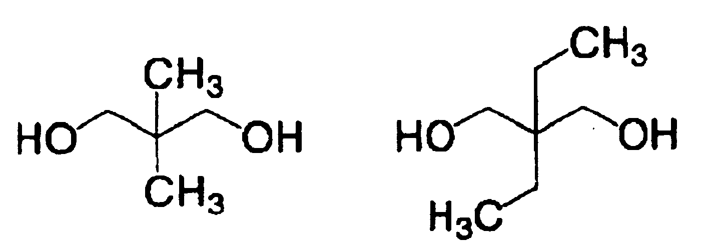

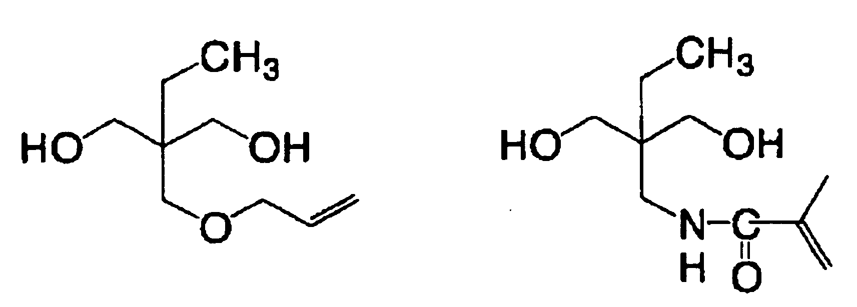

Examples of the diol compounds represented by formula (17) include 2-butene-1,4-diol, and examples of the diol compound represented by formula (18) include cis-2-butene-1,4-diol and trans-2-butene-1,4-diol.

Diol compounds represented by the following formulae (19) and (20) may be preferably used.

HO-L⁸-NH-CO-L⁹-CO-NH-L⁸-OH (19)

HO-L⁹-CO-NH-L⁸-OH (20)

In the formulae, L⁸ and L⁹ may be the same or different and independently represent a divalent aliphatic hydrocarbon group, aromatic hydrocarbon group, or a heterocyclic group which may have a substituent, and examples of the substituent include an alkyl, an aralkyl, an aryl, an alkoxy, an aryloxy, and a halogen atom (-F, -Cl, -Br, -I). If necessary, L⁸ and L⁹ may include another functional group not reactive with the isocyanate group, such as a carbonyl group, an ester group, an urethane group, an amido group, or an ureido group. L⁸ and L⁹ may be bonded to each other to form a ring.

Diol compounds represented by the following formulae (21) and (22) may be preferably used.

HO-Ar²-(L¹⁶-Ar³)ₙ-OH (21)

HO-Ar²-L¹⁶-OH (22)

In the formulae, L¹⁶ represents a divalent aliphatic hydrocarbon group which may have a substituent (examples of the substituent include an alkyl group, an aralkyl group, an aryl group, an alkoxy group, an aryloxy group, and a halogeno group). If necessary, L¹⁶ may include another functional group not reactive with the isocyanate group, such as an ester group, an urethane group, an amido group, or an ureido group.

Ar² and Ar³ may be the same or different and each independently represent a divalent aromatic hydrocarbon group which may have a substituent, and preferably an aromatic group having 6 to 15 carbon atoms. The reference character n represents an integer from 0 to 10.

Specific examples of the diol compounds represented by formula (21) or (22) include the following compounds.

That is, catechol, resorcin, hydroquinone, 4-methylcatechol, 4-tert-butylcetechol, acetylcatechol, 3-methoxycetechol, 4-phenylcetechol, 4-methylresorcin, 4-ethylresorcin, 4-tert-butylresorcin, 4-hexylresorcin, 4-chlororesorcin, 4-benzylresorcin, 4-acetylresorcin, 4-carbomethoxyresorcin, 2-methylresorcin, 5-methylresorcin, tert-butylhydroquinone, 2,5-di-tert-butylhydroquinone, 2,5-di-tert-amylhdyroquinone, tetramethylhydroquinone, tetrachlorohydroquinone, methylcarboaminohydroquinone, methylureidohydroquinone, methylthiohydroquinone, bezonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-(p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dehydroxyanthraquinone, 2-hydroxybenzyl alcohol, 4-hydroxybenzyl alcohol, 2-hydroxy-3,5-di-tert-butylbenzyl alcohol, 4-hydroxy-3,5-di-tert-butylbenzyl alcohol, 4-hydroxyphenethyl alcohol, 2-hydroxyethyl-4-hydroxybenzoate, 2-hydroxyethyl-4-hydroxyphenyl acetate, resorcin mono-2-hydroxyethyl ether, and the like.

Besides the above-mentioned polyurethane resins obtained by introducing the cross-linking group into the side chains at the time of synthesizing polyurethanes, as the binder polymer in the invention, polyurethane resins obtained by introducing the cross-linking group into a polyurethane having a carboxyl group by polymer reaction as described in JP-A No. 2003-270775, may be used.

The molecular weight of the binder polymer to be used in the invention may properly be determined taking into account the image formability and stain resistance. The molecular weight is preferably in a range from 2,000 to 1,000,000, more preferably in a range from 5,000 to 500,000, and even more preferably in a range from 10,000 and 200,000.

The binder polymer to be used in the invention may be used alone or two or more kinds of binder polymers may be used in combination. The binder polymer may be used in form of a mixture of one or more kinds of binder polymers having a cross-linking group and one or more kinds of binder polymers having no cross-linking group in combination. As binder polymers to be used in combination, conventionally known alkali-soluble or swelling binders may be used without particular limitation, and specifically binders having the acryl-based main chain and urethane binders commonly used in this field are preferable.

The content of the binder polymer is generally 20 to 80% by mass and preferably 25 to 75% by mass relative to the total solid content in the coating liquid.

The ratio of the addition polymerizable compound and the binder polymer is preferably (1/9) to (7/3) and more preferably (3/7) to (5/5) as a ratio by weight. Other Components

The coating liquid in the invention may contain a dye or a pigment in order to color the photosensitive layer.

Examples of coloring agents to be used include pigments such as phthalocyanine-based pigments, azo-based pigments, carbon black, and titanium oxide; Ethyl Violet, Crystal Violet, azo-based dyes, anthraquinone-based dyes, and cyanine-based dyes. The addition amount of the dye and the pigment is preferably about 0.5% by mass to about 5% by mass relative to the total composition.

In the coating liquid in the invention, an inorganic filler as well as conventionally known additives such as a plasticizer may be added to improve the physical properties of a cured film of the photosensitive layer.

The plasticizer may be, for example, dioctyl phthalate, didodecyl phthalate, triethylene glycol dicaprylate, dimethyl glycol phthalate, tricresyl phosphate, dioctyl adipate, dibutyl sebacate, and triacetyl glycerin. In the case of using a binder, the plasticizer may be added in an amount of 10% by mass or less relative total mass of the ethylenic compound, the binder and the plasticizer.

In the invention, if necessary, a higher fatty acid derivative such as behenic acid or behenic acid amide may be added to the coating liquid to prevent polymerization inhibition by oxygen and accordingly is allowed to remain in the surface of the photosensitive layer during the drying step after application. The addition amount of the higher fatty acid derivative is preferably about 0.5% by mass to about 10% by mass relative to the total composition.

The coating liquid in the invention may further contain an UV initiator and a thermal cross-linking agent for emphasizing the effect of heating and exposure after development in order to improve the film strength (stain resistance), which will be described later.

Besides, the coating liquid may contain other additives for improving adhesiveness between the photosensitive layer and a support and the developer removable property of the unexposed photosensitive layer. Examples of these additives includes compounds having a diazonium structure and compounds having relatively strong mutual action with the support such as phosphonic acid compounds. Further, hydrophilic polymers such as poly(acrylic acid) and polysulfonic acid may be added to improve the developability of the non-image parts and stain resistance. Organic Solvent

An organic solvent is used for dissolving the above-mentioned respective components for the coating liquid of the invention. Examples of the organic solvent to be used in the invention include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexane, dieacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, and ethyl lactate.

These organic solvents may be used alone or in form of a mixture.

The concentration of the solid content in the coating liquid is properly in a range of 2 to 50% by weight.

### Formation of Photosensitive Layer

In the invention, a photosensitive layer can be formed by applying the coating liquid containing the above-mentioned components to a support. The coating amount of the photosensitive layer on the support is preferably adjusted properly depending on the use since it affects mainly on the sensitivity and the developability of the photosensitive layer, and the strength and the stain resistance of the exposed film. In the case where the coating amount is too small, the stain resistance becomes insufficient. On the other hand, it is too much, the sensitivity is decreased and it takes a long time for exposure and also for development treatment and therefore, it is not preferable.

The coating amount by weight of the planographic printing plate precursor to be obtained in the invention is preferably in a range of about 0.1 g/m² to about 10 g/m² and more preferably from 0.5 to 5 g/m² after drying.

### Support

The support to be used in the invention is preferably those having a hydrophilic face on which the above-mentioned photosensitive layer is to be formed. As the hydrophilic support, conventionally known hydrophilic supports to be used for planographic printing plates can be used without limitation. The support to be used is preferably a plate-shaped material having good dimension stability and examples thereof include paper, paper on which plastics (e.g. polyethylene, polypropylene, and polystyrene) are laminated, metal plates (e.g. of aluminum, zinc, and copper), plastic films (e.g. of cellulose diacetate, cellulose triacetate, cellulose propionate, cellulose butyrate, cellulose acetate butyrate, cellulose nitrate poly(ethylene terephthalate), polyethylene, polystyrene, polypropylene, polycarbonate, and polyvinyl acetal), paper or plastic films on which a metal is laminated or vapor deposited; and the surfaces of these materials may be subjected to conventionally known proper physical and chemical treatment to provide hydrophilicity, improve the strength or the like if necessary.

Preferable examples of the support include paper, a polyester film, and an aluminum plate, and among them, an aluminum plate is more preferable since it is excellent in dimension stability, relatively economical, and may have a surface with good hydrophilicity and strength by surface treatment carried out based on necessity. Also, a composite sheet obtained by bonding an aluminum sheet on a poly(ethylene terephthalate) film as described in JP-B No. 48-18327 is preferable.

Examples of preferable aluminum plate include a pure aluminum plate and an alloy plate containing mainly aluminum and a trace amount of different elements. A plastic film on which aluminum is laminated or vapor deposited is also preferable. The different elements contained in the aluminum alloy may be silicon, iron, manganese, copper, magnesium, chromium, zinc, bismuth, nickel, and titanium. The content of the different elements in the alloy is at highest 10% by mass or less. In the invention, pure aluminum is particularly preferably as the aluminum plate, however it is difficult to produce completely pure aluminum in terms of refining technique, and therefore aluminum may contain a trace amount of different elements. As described, the aluminum plate to be used in the invention is not particularly limited in the composition and conventionally known and employed aluminum plate may properly be used.

The thickness of the aluminum plate to be used in the invention is about 0.1 mm to 0.6 mm, preferably 0.15 mm to 0.4 mm, and more preferably 0.2 mm to 0.3 mm.

In the case where the support has a surface of a metal, particularly, aluminum, it is preferable to carry out surface treatment, e.g. surface roughening (graining) treatment, immersion treatment in an aqueous solution of sodium silicate, potassium fluorozirconate, or a phosphate, or anodization treatment.

The surface roughening treatment of the aluminum plate may be carried out by a variety of methods and for example, it may be carried out by a method for mechanical surface-roughening, an electrochemical method for dissolving and roughening the surface, and a method for chemically selectively dissolving the surface. As the mechanical methods any conventional method such as a ball grinding method, a brush grinding method, a blast grinding method, a buff grinding method or the like may be uised. As the electrochemical surface-roughening method, a method carried out by applying a.c. or d.c. voltage in an electrolytic solution such as hydrochloric acid, nitric acid, or the like may be used. Also, as disclosed in JP-A No. 54-63902, a method involving both methods in combination may also be employed. Further, prior to the surface-roughening the aluminum plate, if desired, to remove the rolling oil on the surface, degreasing treatment by a surfactant, an organic solvent, or an aqueous alkaline solution may be carried out.

Further, an aluminum plate which has been subjected to immersion treatment in an aqueous sodium silicate solution after surface roughening may preferably be used. Also, as described in JP-B No. 47-5125, an aluminum plate which has been subjected to immersion treatment in an aqueous alkali metal silicate solution after anodization treatment may preferably be used. The anodization treatment is carried out by using an aluminum plate as an anode and applying electric current in an electrolytic solution containing one or more kinds of aqueous or non-aqueous solutions containing an inorganic acid such as phosphoric acid, chromic acid, sulfuric acid, or boric acid; an organic acid such as oxalic acid or sulfamic acid; or their salts. Silicate electrodeposition as described in US Patent No. 3,658,662 is also effective.

Further, use of a support subjected to electrolytic grain treatment disclosed in JP-B No. 46-27481 and JP-A Nos. 52-58602 and 52-30503 and combined surface treatment of the above-mentioned anodization and sodium silicate treatment is also useful.

Those subjected successively to mechanical surface-roughening, chemical etching, electrolytic grain treatment, anodization, and sodium silicate treatment as disclosed in JP-A No. 56-28893 are also preferable.

Further, after being subjected to these treatments, those which are under-coated with a water-soluble resin such as polyvinyl phosphonic acid and polymers and copolymers having a sulfonic acid group in the side chains, poly(acrylic acid), a water-soluble metal salt (e.g. zinc borate), yellow dye, or an amine salt are also preferable.

Further, a substrate which has been subjected to sol-gel treatment of forming conjugation bond of a functional group capable of causing addition reaction by radical as described in JP-A No. 5-304358 is also preferably used.

Additionally, a support obtained by forming a water-proof hydrophilic layer as a surface layer on any support can be exemplified as a preferable example. Such a surface layer may be layers containing inorganic pigments and binders as described in US Patent No. 3,055,295 and JP-A No. 56-13168; hydrophilic swelling layers as described in JP-A No. 9-80744; and sol-gel films containing titanium oxide, polyvinyl alcohol, and silicates as described in JP-A No. 8-507727.

These hydrophilic treatments carried out to make the surface of the support hydrophilic, and are carried out also to prevent an adverse reaction of the photosensitive layer to be formed thereon and to improve the adhesion strength of the photosensitive layer.

If necessary, a back coat may be formed on the rear face of the support.

As the back coat, a coating layer containing an organic high molecular weight compound described in JP-A No. 5-45885 or a coating layer containing a metal oxide obtained by hydrolysis or condensation polymerization of organic or inorganic metal compound described in JP-A No. 6-35174 is preferably used.

Since alkoxy compounds of silicon such as Si(OCH₃)₄, Si(OC₂H₅)₄, Si(OC₃H₇)₄, and Si(OC₄H₉)₄ are economical and easily available, coating layers containing metal oxides derived from these alkoxy compounds are excellent in development resistance and therefore particularly preferable among these coating layers. Protective Layer

An embodiment of the invention may be a scanning a planographic plate precursor, and it is preferable to provide a protective layer on the photosensitive layer in the scanning planographic plate precursor to enable exposure of the precursor in an atmosphere. The protective layer prevents low molecular-weight compounds which inhibit image forming reaction caused by exposure of the photosensitive layer, such as oxygen and basic substances existing in an atmosphere, from entering the photosensitive layer, which makes it possible to conduct exposure in an atmosphere. Accordingly, a property which the protective layer is required to have is that the permeating property of the low molecular weight compounds such as oxygen in the protective layer is low. Moreover, it is preferable that the protective layer does not substantially inhibit light used to expose the planographic printing plate precursor from passing through the protective layer, has strong adhesion between the protective layer and the photosensitive layer, and can be easy to remove in the development step of an exposed printing plate. Devices relating to a protective layer satisfying the above demands have been conventionally implemented, as detailed in U.S. Patent No. 3,458,311 and JP-B No. 55-49729.

The material of the protective layer is preferably a relatively good crystalline, water-soluble and high molecular weight compound. Specifically, water-soluble polymers such as polyvinyl alcohol, polyvinyl pyrrolidone, acidic celluloses, gelatin, gum arabic and polyacrylic acid are known as such. However, use of polyvinyl alcohol as the main component of the protective layer is effective in obtaining best basic characteristics such as an oxygen-blocking property and removability during development. Polyvinyl alcohol used in the protective layer may be partly substituted with ester, ether and/or acetal, insofar as it contains an unsubstituted vinyl alcohol unit for achieving an oxygen-blocking property and water-solubility, which are essential to the protective layer. In addition, a part thereof may have other copolymerizing component.

The polyvinyl alcohol can be one which have been hydrolyzed in a proportion of 71 to 100% and which have a molecular weight in the range of 300 to 2,400. Specific examples of such polyvinyl alcohol include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 manufactured by Kuraray Co., Ltd.

The components of the protective layer (kind of PVA, and use of other additives) and the amounts thereof are determined according to a desired oxygen-blocking property, removability during development, fogging property, adhesiveness, and scratch resistance of the protective layer. Generally, the higher the hydrolysis rate of the PVA (the higher the content of unsubstituted vinyl alcohol units in the protective layer), the better the oxygen-blocking property of the protective layer and the sensitivity of the printing plate precursor. Moreover, the thicker the protective layer, the better the oxygen-blocking property of the protective layer and the sensitivity of the printing plate precursor. However, extreme rising of the oxygen-blocking property may lead to undesirable polymerization reaction during production and storage, and fogging, which is undesired, and thickening of image lines during image exposure. Adhesion between the protective layer and the image portions and scratch resistance of the protective layer are also very important in handling printing plates. When a printing plate has a hydrophilic layer made of a water-soluble polymer and laminated on a photosensitive layer, which is oleophilic, these layers insufficiently adhere to each other, which causes the hydrophilic layer to often and undesirably separate from the printing plate. Portions of the printing plate having no protective layer are exposed to air, and oxygen included in the air inhibits polymerization in the photosensitive layer, generating defects such as insufficient hardening of the photosensitive layer. In order to solve this problem, various methods for improving adhesion between the two layers have been proposed. For example, certain U.S. Patents disclose that a hydrophilic layer having strong adhesion between a photosensitive layer and the hydrophilic layer can be obtained by adding 20 to 60 % by mass of an acrylic emulsion or a water-insoluble vinylpyrrolidone-vinyl acetate copolymer to a hydrophilic polymer mainly containing polyvinyl alcohol and applying the resulting composition onto a photosensitive layer.

These conventionally known techniques may be applied to the protective layer used in the invention. Methods of forming such a protective layer are detailed in, for example, U.S. Patent No. 3,458,311 and JP-B No. 55-49729.

Further, the protection layer may have another function. For example, addition of a coloring agent (e.g. a water-soluble dye) excellent in transmission of light at wavelength in a range of 350 nm to 450 nm which is used for exposure, and capable of efficiently absorbing light at wavelength of 500 nm or longer increases the safe light suitability without deterioration of the sensitivity.

### Undercoat Layer (Intermediate Layer)

The planographic printing plate precursor obtained by the invention may have an undercoat layer between the photosensitive layer and the support to improve adhesiveness between the photosensitive layer and the support and increase the developer removable property in the unexposed region of the photosensitive layer.

A compound capable of causing mutual action with the support may be used for the undercoat layer and specific examples thereof include compounds having a diazonium structure and phosphonic compounds. To improve the property to remove the non-image part region, it is preferable to use hydrophilic polymers such as poly(acrylic acid) and poly(sulfonic acid) for the undercoat layer.

### Plate Making

The plate making method using the planographic printing plate precursor obtained by the method of producing a planographic printing plate precursor of the invention will be described.

The planographic printing plate precursor obtained in the above-mentioned manner shows excellent properties for plate making, particularly by scanning exposure.

A general method of scanning exposure is described in Yoshisuke TAKEKIDA, Optical Printer Design, Triceps (1985). That is, using light in form of beam (normally having a radius from several micron to several tens micron) as a light source, main scanning of a printing plate precursor is carried out in a certain direction and simultaneously auxiliary scanning (laser scanning) is carried out perpendicularly to the direction to expose the entire plate precursor and at the time, corresponding to the image information, on/off of the exposure is controlled to carry out image-wise exposure. To carry out image exposure with higher resolution, it is required to use beam with a smaller radius and in that case, to draw an image in the entire plate with a large surface area within a short time, it is required to increase the scanning speed and/or to increase the number of beams. In the case where specific exposure duration is to be guaranteed in a scanning exposure system, the exposure time at respective points on the printing plate precursor is generally as short as micro second or shorter. Therefore, it is required to use a continuously oscillating high power light source for supplying a sufficient exposure energy amount to the sensitive material for the printing plate precursor.

Presently, various laser beams capable of continuously oscillating in visible light region to infrared ray region (e.g. Ar, FD-YAG, He-Ne, LD, and YAG) are used as such a light source and in terms of the balance between the sensitivity and the power of economical and easily available laser, a visible light source of Ar ion laser (488 nm) and FD-YAG (532 nm) with an output power of about several ten to several hundred W can be selected.

With respect to the planographic printing plate precursor obtained by the invention, the type and the wavelength of the light source may properly be selected depending on the type of the photosensitive composition forming the photosensitive layer and for example, it is possible to carry out scanning exposure by using a light source with shorter wavelength (blue and/or ultraviolet laser), a light source with longer wavelength (red, and infrared laser), or other light sources. Particularly, in these years, short wavelength semiconductor laser (blue and/or ultraviolet laser) using a GaN-based material has actively been developed. The planographic printing plate precursor of the invention may be preferably used for scanning exposure with such laser.

After the planographic printing plate precursor obtained in the invention is image-wise exposed, unexposed parts in the photosensitive layer are removed by a developer to obtain an image.

As a preferable developer, those described in JP-B No. 57-7427 may preferably used, and specific examples include aqueous solutions of inorganic alkali agents such as sodium silicate, potassium silicate, sodium hydroxide, potassium hydroxide, lithium hydroxide, sodium tertiary phosphate, dibasic sodium phosphate, ammonium tertiary phosphate, dibasic ammonium phosphate, sodium metasilicate, sodium hydrogen carbonate, and ammonia water; and organic alkaline agents such as monoethanol amine and diethanol amine. The alkali agents are preferably added in a concentration of 0.1 to 10% by mass and preferably 0.5 to 5% by mass.

Such aqueous alkaline solutions may contain a small amount of a surfactant and an organic solvent such as a benzyl alcohol, 2-phenoxyethanol, and 2-butoxyethanol based on the necessity. Examples thereof include those described in US Patent Nos. 3,375,171 and 3,615,480. Further, developers described in JP-A Nos. 50-26601 and 58-54341 and JP-B Nos. 56-39464 and 56-42860 are also excellent.

The planographic printing plate which has been subjected to the development in the above-mentioned manner is preferably subjected to post-treatment with washing water, a rinsing solution containing a surfactant, or a solution insensible to fats and oils containing gum arabic or a starch derivative.

If necessary, the print making process may include heating the entire surface before exposure, during exposure, or during the time from exposure to development. Heating promotes the image formation reaction in the photosensitive layer and causes advantageous effects such as improvement of sensitivity and stain resistance and stabilization of the sensitivity. Further, it is also effective to carry out post-heating of the entire surface or entire surface exposure to the image after development in order to improve the image strength and stain resistance. In general, heating before development is preferably carried out in a moderate condition at 150°C or lower. If the temperature is too high, it may results in a problem of fogging in the non-image parts. Heating after development may be carried out under very strong condition. It is generally at a temperature in a range of 200 to 500°C. If the temperature is too low, no sufficient image strengthening effect can be caused and if it is too high, a problem such as deterioration of the support or thermal decomposition of the image parts may possible be caused.

The planographic printing plate obtained by the above-mentioned treatment is employed in an off-set printer to carry out printing in a large number of printing sheets.

### EXAMPLES

The invention will be described more in detail along with examples. However, it is not intended that the invention be limited to the described examples.

### Example 1

### Production of Support

After a 1 S web-shaped aluminum plate with a thickness of 0.30 mm was etched by immersing it in 10% sodium hydroxide at 70°C for 60 seconds, the plate was washed with flowing water, rinsed and neutralized with 20% HNO₃, and washed with water. The plate was electrolytically surface-roughened by applying alternating current in sinusoidal waveform at VA = 12.7 V in an aqueous 1% nitric acid solution and an electric quantity when the aluminum plate served as an anode was 300 C/dm². The surface roughness was measured to find it was 0.45 µm (based on Ra).

Successively, after the plate was immersed in an aqueous 30% H₂SO₄ solution and subjected to desmutting treatment at 55°C for 2 minutes, the plate was anodized at a current density of 5A/dm² for 50 seconds in an aqueous 20% H₂SO₄ solution at 33°C by setting a cathode in the grained face to form an anodized film with a thickness of 2.7 g/m². The anodized film in the rear face was about 0.2 g/m² in the center part and about 0.5 g/m² in the edge part of the aluminum plate.

The rear face of the substrate treated in the above-mentioned manner was coated with the following coating liquid for a back coat layer formation using sol-gel reaction liquid and dried until the temperature of the aluminum plate reached 60°C, and after that, a support having a back coat layer of the coating liquid in an amount of 50 mg/m² was produced.

**<Sol-gel reaction liquid>**

| | |
|---|---|
| tetraethylsilicate | 50 parts by mass |
| water | 20 parts by mass |
| methanol | 10 parts by mass |
| phosphoric acid | 0.07 parts by mass |

When the above-mentioned components were stirred, heat generation began in about 5 minutes. After 30-minute reaction, the following liquid was added to prepare the coating liquid for the back coat.

| | |
|---|---|
| pyrogallol formaldehyde condensation resin (molecular weight (Mw) 2000) | 4 parts by mass |
| dimethyl phthalate | 5 parts by mass |
| methanol | 1000 parts by mass |

### Formation of Undercoat Layer

An undercoat layer was formed on the aluminum plate treated in the above-mentioned manner and having the back coat layer by the following method.

At first, the following liquid composition for the undercoat was mixed and stirred at 30°C. After about 5 minutes, heat generation occurred and the composition was reacted for 60 minutes and successively, the content was transferred to another container and 10000 parts by mass of methanol was added to prepare a coating liquid for the undercoat layer.

Thereafter, the obtained coating liquid for the undercoat layer was applied to the above-mentioned aluminum plate while the coating amount was adjusted to be 0.1 g/m² and the aluminum plate was dried until the temperature of the aluminum plate reached 70°C and then the aluminum plate was cooled to 50°C or lower to form the undercoat layer.

**<Liquid composition for undercoat>**

| | |
|---|---|
| compound of the following structure (formula (E2)) | 96 parts by mass |
| methanol | 100 parts by mass |
| water | 14 parts by mass |
| phosphoric acid (85% aqueous solution) | 11 parts by mass |
| tetraethoxysilane | 36 parts by mass |
| 3-methacryloxypropyltrimethoxysilane | 50 parts by mass |

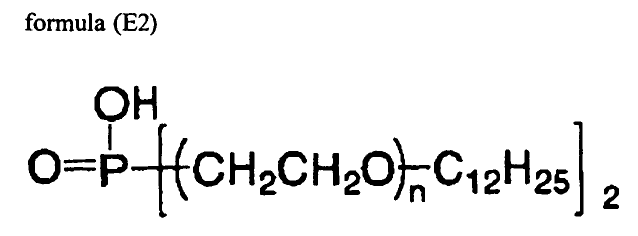

In formula (E2), n represents an integer from 4 to 20.

### Formation of Photosensitive Layer

A coating liquid for a photosensitive layer with the following composition was prepared as a coating liquid in the method of producing the photosensitive planographic printing plate precursor of the invention. In the liquid preparation tank 10 as shown in Fig. 1, the coating liquid for the photosensitive layer in the liquid preparation tank 10 was controlled by the control part 22 to be at 23.0°C to 27.9°C and the dissolved oxygen amount in the coating liquid was controlled by the control part 22 to be 8.0 mg/l or higher, that is the dissolved oxygen amount was controlled not to be less than 8.0 mg/l.

More specifically, the control part 22 obtains the measurement result measured at every prescribed period by the dissolved oxygen meter 24 and determines whether the measurement result is less than an alarming amount, 8.2 mg/l, or not. The motor 30 is controlled by the control part 22 so as to start stirring of the coating liquid stored in the liquid preparation tank 10 by the stirring member 26 when the result is found less than the alarming amount. By controlling in the above-mentioned manner, the dissolved oxygen amount was kept equal to or higher than 8.0 mg/l in the coating liquid in the liquid preparation tank 10.

After that, the coating liquid in the liquid preparation tank 10 was transferred to the stock tank 12 and circulated in the stock tank 12 to keep the dissolved oxygen amount equal to 8.0 mg/l or higher.

More specifically, the control part 22 obtains the measurement result measured at every prescribed period by the dissolved oxygen meter 25, and determines whether the measurement result is less than an alarming amount, 8.2 mg/l, or not. The circulation pump 36 is controlled by the control part 22 so as to operate when the result was found less than the alarming amount. By controlling in the above-mentioned manner, the dissolved oxygen amount was kept equal to or higher than 8.0 mg/l in the coating liquid in the stock tank 12.

The coating liquid stored in the stock tank 12 was supplied to a coating apparatus 16 via a reservoir 14.

The coating liquid was applied to the undercoat layer formed as described in a proper amount to control the dried coating amount to be 1.4 g/m² and dried until the temperature of the aluminum plate reached 100°C, and after that, the aluminum plate was cooled to 50°C and thus the photosensitive layer was formed.

The coating liquid for the photosensitive layer in the Example 1 was kept at 26°C for 120 hours from the time of preparation to the time of application.

**<Coating liquid for photosensitive layer>**

| | |
|---|---|
| polymerizable compound (polymerizable compound A shown below) | 4.5 parts by mass |
| binder polymer (binder polymer B shown below) | 5.3 parts by mass |
| sensitizing dye (sensitizing dye C shown below) | 0.4 parts by mass |
| polymerization initiator (polymerization initiator D shown below) | 0.9 parts by mass |
| chain transferring agent (chain transfer agent E shown below) | 0.5 parts by mass |
| ε-phthalocyanine pigment dispersion (pigment: 15 parts by mass; allyl methacrylate/methacrylic acid copolymer dispersant (copolymerization ratio by mole 83/18): 10 parts by mass; cyclohexanone: 15 parts by mass) | 0.9 parts by mass |
| fluorine-based nonionic surfactant (trade name: MEGAFACE F 780, manufactured by Dainippon Ink and Chemicals, Inc.) | 0.02 parts by mass |
| thermal polymerization inhibitor: N-nitrosophenylhydroxylamine aluminum salt | 0.03 parts by mass |
| methyl ethyl ketone | 58 parts by mass |
| propylene glycol monomethyl ether acetate | 53 parts by weight |

The structures of the respective components of the coating liquid for the photosensitive layer are shown as follows.

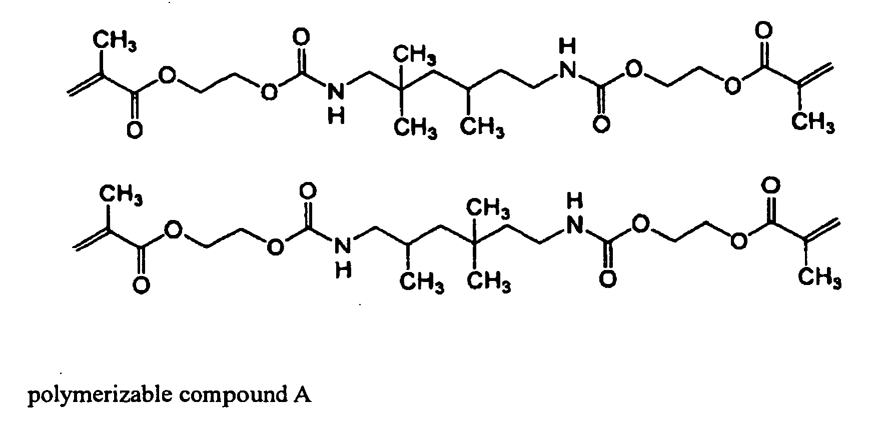

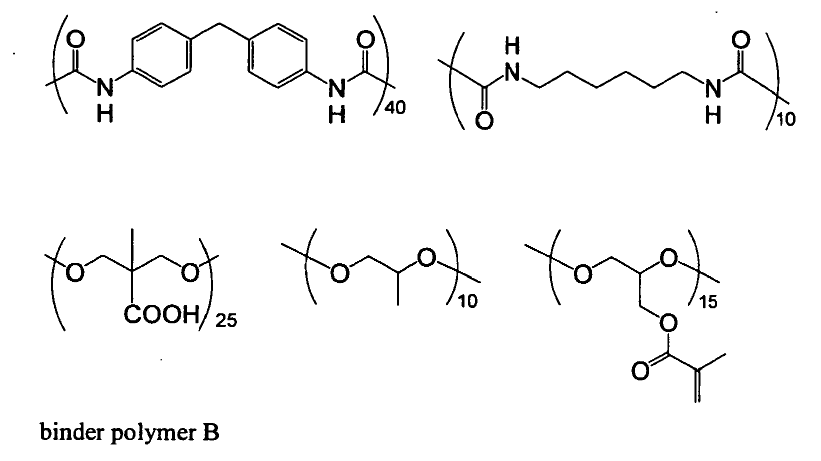

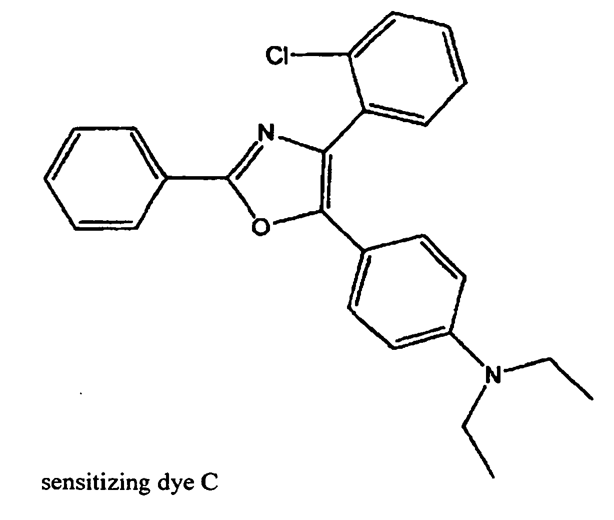

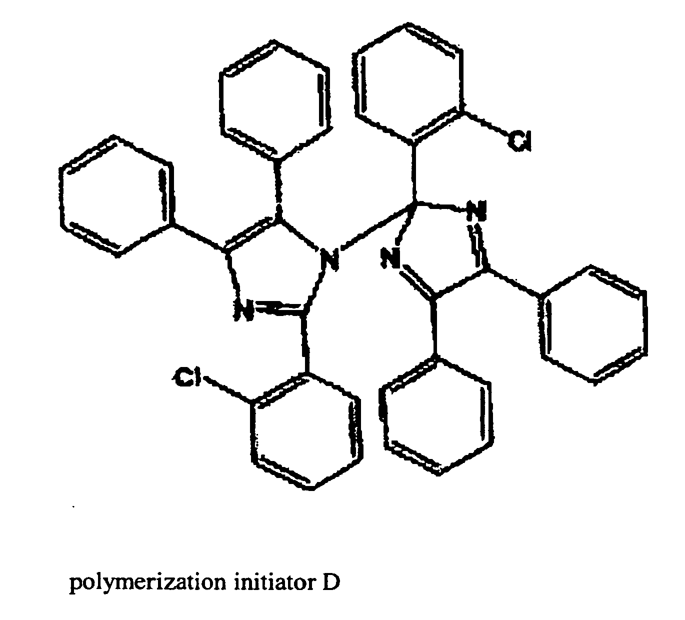

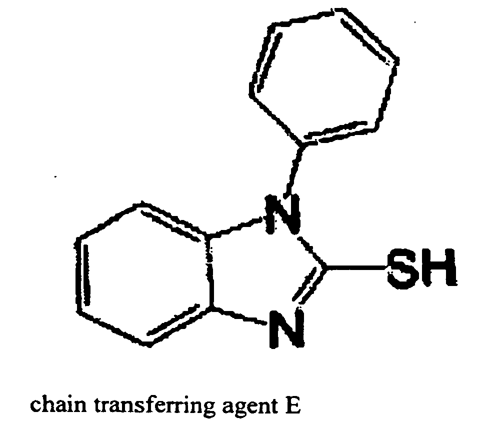

### Formation of Overcoat Layer

A coating liquid for an overcoat layer with the following composition was applied to the obtained photosensitive layer in a proper amount to control the dried coating amount to be 2.2 g/m² and dried until the crystallization degree of the polyvinyl alcohol to be 0.45 and after that, the aluminum plate was cooled to 50°C or lower.

**<Coating liquid for overcoat layer>**

| | |
|---|---|
| polyvinyl alcohol (PVA-105 manufactured by Kuraray Co., Ltd.; saponification degree 98% by mole; polymerization degree 500) | 20 parts by mass |
| polyvinylpyrrolidone (trade name: K 30, manufactured by Wako Pure Chemical Industries, Ltd.) | 2 parts by mass |
| nonionic surfactant (trade name: EMAREX NP-10, manufactured by Nihon Emulsion Co., Ltd.) | 0.5 parts by mass |
| distilled water | 360 parts by mass |

After that, the water content in the overcoat layer was adjusted to be 4.0% and successively the resultant plate was once rolled in form of a web roll. While the following interleaf paper was attached to the web roll, the plate was cut in a sheet to obtain a photosensitive planographic printing plate precursor.

While the water content in the overcoat layer was measured by an infrared component measurement meter (IRM-V, manufactured by Chino Co., Ltd.), the production was carried out and when the water content was out of the prescribed range, the moisture was adjusted so as to keep water content at 4.0% by a temperature and humidity control apparatus (not illustrated).

### Interleaf Paper

Bleached kraft pulp was beaten and distilled to 4% concentration. The paper material was mixed with 0.4% by mass of a synthesized sizing agent, and further, aluminum sulfate was added thereto until pH reached 5.0. A paper reinforcing agent mainly containing starch was applied in an amount of 3.0% by mass to the resulting paper material and paper making was carried out to obtain paper of 38 g/m² with a density 0.75 g/m², smoothness of 25 seconds, a water content of 6.0% by mass.

### Example 2

A photopolymerizable planographic printing plate precursor was produced in the same manner as in Example 1, except that after the preparation of the coating liquid for the photosensitive layer, only the stirring was carried out in the liquid preparation tank 10 and after the transfer to the stock tank 12, the circulating of the coating liquid in the stock tank 12 was not carried out and the dissolved oxygen concentration was kept at 8.0 mg/l or higher.

### Example 3

A photopolymerizable planographic printing plate precursor was produced in the same manner as in Example 1, except that after the preparation of the coating liquid for the photosensitive layer, the stirring was not carried out in the liquid preparation tank 10 and after the transfer to the stock tank 12, only the circulating of the coating liquid in the stock tank 12 was carried out and the dissolved oxygen concentration was kept at 8.0 mg/l or higher.

### Example 4

A photopolymerizable photosensitive planographic printing plate precursor was produced in the same manner as in Example 1, except that after the preparation of the coating liquid for the photosensitive layer, neither stirring in the liquid preparation tank 10 nor circulating of the coating liquid in the stock tank 12 was carried out, and the coating liquid was applied before the dissolved oxygen concentration was lowered to less than 8.0 mg/l. The duration from the preparation to the application was determined based on the time when the dissolved oxygen concentration became lower than 8.0 mg/l calculated previously from the dissolved oxygen decreasing speed after the coating liquid preparation. Also, it was confirmed that the dissolved oxygen concentration in the coating liquid immediately before coating was 8.0 mg/l by a dissolved oxygen meter.

The coating liquid for the photosensitive layer in Example 4 was kept at 26°C for 24 hours from the time of preparation to the time of application.

### Example 5

A photopolymerizable planographic printing plate precursor was produced in the same manner as in Example 1, except that after the preparation of the coating liquid for the photosensitive layer, air was injected into the coating liquid for the photosensitive layer to control the dissolved oxygen concentration to be 8.0 mg/l or higher and lower than 10.0 mg/l.

### Comparative Example 1

A photopolymerizable planographic printing plate precursor was produced in the same manner as in Example 1, except that after the preparation of the coating liquid for the photosensitive layer, the coating liquid was applied to the support after the dissolved oxygen concentration to be lower than 8.0 mg/l.

### Evaluation

Each of the photopolymerizable planographic printing plate precursors produced in Examples 1 to 5 and Comparative Example 1 was image-wise exposed at 909 dpi under the condition of 100 line/inch while the exposure dose on the photopolymerizable photosensitive planographic printing plate precursor was controlled to be 0.05 mJ/cm² by using Vx 9600 CTP (light source wavelength: 405 nm; manufactured by Fuji Photo Film Co., Ltd).

After the exposure, the resulting plate was subjected to post-heating treatment, and then, washed with water. After that the plate was subjected to standard development treatment with a developer DV-2 diluted solution (DV-2 : water = 1 : 4, manufactured by Fuji Photo Film Co., Ltd.) and finishing gum solution FN-6 (FN-6 : water = 1 : 3, manufactured by Fuji Photo Film Co., Ltd.) by an automated developing machine FLP 125NFS manufactured by Fuji Photo Film Co., Ltd.. The developer temperature was 25°C and the immersion duration in the developer was about 22 seconds.

### Evaluation of Sensitivity

For measuring the sensitivity, 50% halftone dot surface area was measured by using Macbeth densitometer RD 920. The closer the result to 50%, the higher the sensitivity and the better the halftone dot reproducibility. The results are shown in the following Table 1. Evaluation of Developability

The developability in the non-image parts of each planographic printing plate obtained by the above-mentioned exposure and development treatments was observed. Developability means whether the unexposed parts in the photosensitive layer are removed or not. "A" shows the unexposed parts were found not being colored with the remaining photosensitive layer with visual observation. "B" shows the unexposed parts were found being colored because of the remaining photosensitive layer with visual observation. The results are shown in the following Table 1.

### Evaluation of Stain Resistance

Stain resistance was evaluated after printing was carried out on 1000 sheets by using each planographic printing plate obtained by the above-mentioned exposure and development treatments, a printing apparatus (trade name: Lithron, manufactured by KOMORI Corporation), black ink DIC-GEOS (N) manufactured by Dainippon Ink and Chemicals, Inc., and an etching solution EU-3/water/isopropyl alcohol = 1/89/10 (by volume) manufactured by Fuji Photo Film Co., Ltd.

In the case where the ink was deposited on an originally blank portion at the time of printing, "B" was marked, and in the case where stain-free and excellent printing was obtained, "A" was marked.

**Table 1**

| | 50% Halftone Dot Sensitivity | Developability | Stain Resistance |
|---|---|---|---|
| Example 1 | 50% | A | A |
| Example 2 | 50% | A | A |
| Example 3 | 50% | A | A |
| Example 4 | 50% | A | A |
| Example 5 | 50% | A | A |
| Comparative Example 1 | 60% | B | B |

According to Table 1, photosensitive planographic printing plate precursors of Examples 1 to 5 produced by the production method of the invention were found excellent in all of sensitivity, developability, and stain resistance as compared with the photosensitive planographic printing plate precursor of Comparative Example 1 in which the coating liquid was applied after the dissolved oxygen concentration became less than 8.0 mg/l.

According an aspect of the invention, a method of producing a planograpnic printing plate precursor having uniform developability and excellent staining resistance can be provided.

Hereinafter, embodiments of the present invention will be described. However, the invention is not limited to the following embodiments.

According to an aspect of the invention, there is provided a method of producing a photosensitive planographic printing plate precursor comprising:
preparing a coating liquid by dissolving at least a compound having an addition polymerizable ethylenic double bond and a polymerization initiator in an organic solvent; and
applying the coating liquid to a support,
wherein a dissolved oxygen content in the coating liquid from the preparation of the coating liquid to the application of the coating liquid to the support is kept at 8.0 mg/l or higher.

In an embodiment, the compound having an addition polymerizable ethylenic double bond may be a compound having two or more terminal polymerizable ethylenic double bonds.

In an embodiment, the compound having the addition polymerizable ethylenic double bond may be contained in the coating liquid in an amount of 20 to 80% by mass relative to the total solid content of the coating liquid.

In an embodiment, the polymerization initiator may be a hexaaryl biimidazole compound, a compound having a carbon-halogen bond, an onium compound, or a metallocene compound.

In an embodiment, the polymerization initiator may be contained in the coating liquid in an amount of 0.01 to 1.0% by mass relative to the total solid content of the coating liquid.

In an embodiment, the coating liquid may further contain a sensitizing dye.

In an embodiment, the sensitizing dye may be contained in the coating liquid in an amount of 0.05 to 30% by mass relative to the total solid content of the coating liquid.

In an embodiment, the coating liquid may further contain co-initiator selected from the group consisting of halogenated hydrocarbon compounds, ketone compounds, ketoxime compounds, organic peroxides, thio compounds, hexaaryl biimidazoles, aromatic onium compounds, and oxime ethers.

In an embodiment, the production method of a photosensitive planographic printing plate precursor may further comprise supplying oxygen to the coating liquid by stirring the coating liquid.

In an embodiment, the production method of a photosensitive planographic printing plate precursor may further comprise supplying oxygen to the coating liquid by circulating the coating liquid.

In an embodiment, the production method of a photosensitive planographic printing plate precursor may further comprise supplying oxygen to the coating liquid by injecting air into the coating liquid.

The foregoing description of the embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

## Claims

1. A method for producing a photosensitive planographic printing plate precursor comprising:
preparing a coating liquid by dissolving at least a compound having an addition polymerisable ethylenic double bond and a polymerisation initiator in an organic solvent; and
applying the coating liquid on a support,
**characterised in that** the method further comprises degassing the coating liquid by a degassing apparatus before its application on the support, and the content of dissolved oxygen in the coating liquid from its preparation to the time immediately before degassing by the degassing apparatus is kept at 8.0 mg/l or higher.

2. A method according to Claim 1, wherein the compound having an addition polymerisable ethylenic double bond is a compound having two or more terminal polymerisable ethylenic double bonds.

3. A method according to Claim 1, wherein the compound having an addition polymerisable ethylenic double bond is contained in the coating liquid in an amount of 20 to 80% by mass relative to the total solid content of the coating liquid.

4. A method according to Claim 1, wherein the polymerisation initiator is a hexaaryl biimidazole compound, a compound having a carbon-halogen bond, an onium compound or a metallocene compound.

5. A method according to Claim 1, wherein the polymerisation initiator is contained in the coating liquid in an amount of 0.01 to 1.0% by mass relative to the total solid content of the coating liquid.

6. A method according to Claim 1, wherein the coating liquid further comprises a sensitising dye.

7. A method according to Claim 6, wherein the sensitising dye is contained in the coating liquid in an amount of 0.05 to 30% by mass relative to the total solid content of the coating liquid.

8. A method according to Claim 1, wherein the coating liquid further comprises as a co-initiator a halogenated hydrocarbon compound, a ketone compound, a ketoxime compound, an organic peroxide, a thio compound, a hexaaryl biimidazole, an aromatic onium compound or an oxime ether.

9. A method according to Claim 1, wherein oxygen is supplied to the coating liquid by stirring the coating liquid.

10. A method according to Claim 1, wherein oxygen is supplied to the coating liquid by circulating the coating liquid.

11. A method according to Claim 1, wherein oxygen is supplied to the coating liquid by injecting air into the coating liquid.

## Patentansprüche

1. Verfahren zur Herstellung eines fotoempfindlichen Flachdruckplattenvorläufers, umfassend:
Herstellen einer Beschichtungsflüssigkeit durch Auflösen von zumindest einer Verbindung, die eine additionspolymerisierbare ethylenische Doppelbindung aufweist, und eines Polymerisationsinitiators in einem organischen Lösungsmittel; und
Auftragen der Beschichtungsflüssigkeit auf einen Träger,
**dadurch gekennzeichnet, dass** das Verfahren ferner das Entgasen der Beschichtungsflüssigkeit durch eine Entgasungsvorrichtung vor ihrer Auftragung auf den Träger umfasst und der Gehalt des gelösten Sauerstoffs in der Beschichtungsflüssigkeit von ihrer Herstellung bis zum Zeitpunkt unmittelbar vor dem Entgasen mit der Entgasungsvorrichtung bei 8,0 mg/l oder höher gehalten wird.

2. Verfahren gemäß Anspruch 1, worin die Verbindung, die eine additionspolymerisierbare ethylenische Doppelbindung aufweist, eine Verbindung mit zwei oder mehr endständigen polymerisierbaren ethylenischen Doppelbindungen ist.

3. Verfahren gemäß Anspruch 1, worin die Verbindung, die eine additionspolymerisierbare ethylenische Doppelbindung aufweist, in der Beschichtungsflüssigkeit in einer Menge von 20 bis 80 Masse% enthalten ist, relativ zum Gesamtfeststoffgehalt der Beschichtungsflüssigkeit.

4. Verfahren gemäß Anspruch 1, worin der Polymerisationsinitiator eine Hexaarylbiimidazolverbindung, eine Verbindung mit einer Kohlenstoff-Halogen-Bindung, eine Oniumverbindung oder eine Metallocenverbindung ist.

5. Verfahren gemäß Anspruch 1, worin der Polymerisationsinitiator in der Beschichtungsflüssigkeit in einer Menge von 0,01 bis 1,0 Masse% enthalten ist, relativ zum Gesamtfeststoffgehalt der Beschichtungsflüssigkeit.

6. Verfahren gemäß Anspruch 1, worin die Beschichtungsflüssigkeit ferner einen Sensibilisierungsfarbstoff umfasst.

7. Verfahren gemäß Anspruch 6, worin der Sensibilisierungsfarbstoff in der Beschichtungsflüssigkeit in einer Menge von 0,05 bis 30 Masse% enthalten ist, relativ zum Gesamtfeststoffgehalt der Beschichtungsflüssigkeit.

8. Verfahren gemäß Anspruch 1, worin die Beschichtungsflüssigkeit ferner eine halogenierte Kohlenwasserstoffverbindung, eine Ketonverbindung, eine Ketoximverbindung, ein organisches Peroxid, eine Thioverbindung, ein Hexaarylbiimidazol, eine aromatische Oniumverbindung oder einen Oximether als einen Co-Initiator umfasst.

9. Verfahren gemäß Anspruch 1, worin Sauerstoff zu der Beschichtungsflüssigkeit durch Rühren der Beschichtungsflüssigkeit zugeführt wird.

10. Verfahren gemäß Anspruch 1, worin Sauerstoff zu der Beschichtungsflüssigkeit durch Zirkulieren der Beschichtungsflüssigkeit zugeführt wird.

11. Verfahren gemäß Anspruch 1, worin Sauerstoff zu der Beschichtungsflüssigkeit durch Einblasen von Luft in die Beschichtungsflüssigkeit zugeführt wird.

## Revendications

1. Procédé de production d'un précurseur de plaque d'impression planographique photosensible comprenant le fait :
de préparer un liquide de revêtement par dissolution d'au moins un composé ayant une double liaison éthylénique polymérisable par addition et un initiateur de polymérisation dans un solvant organique ; et
d'appliquer le liquide de revêtement sur un support,
**caractérisé en ce que** le procédé comprend en outre le fait de dégazer le liquide de revêtement par un appareil de dégazage avant son application sur le support, et la teneur en oxygène dissous dans le liquide de revêtement à partir de sa préparation jusqu'au moment juste avant le dégazage par l'appareil de dégazage est maintenue à 8,0 mg/l ou plus.

2. Procédé selon la revendication 1, dans lequel le composé ayant une double liaison éthylénique polymérisable par addition est un composé ayant deux doubles liaisons éthyléniques terminales polymérisables ou plus.

3. Procédé selon la revendication 1, dans lequel le composé ayant une double liaison éthylénique polymérisable par addition est présent dans le liquide de revêtement en une quantité allant de 20 à 80% en masse par rapport à la teneur en matière solide totale du liquide de revêtement.

4. Procédé selon la revendication 1, dans lequel l'initiateur de polymérisation est un composé hexaarylbiimidazole, un composé ayant une liaison carbone-halogène, un composé d'onium ou un composé métallocène.

5. Procédé selon la revendication 1, dans lequel l'initiateur de polymérisation est présent dans le liquide de revêtement en une quantité allant de 0,01 à 1,0% en masse par rapport à la teneur en matière solide totale du liquide de revêtement.

6. Procédé selon la revendication 1, dans lequel le liquide de revêtement comprend en outre un colorant sensibilisateur.

7. Procédé selon la revendication 6, dans lequel le colorant sensibilisateur est présent dans le liquide de revêtement en une quantité allant de 0,05 à 30% en masse par rapport à la teneur en matière solide totale du liquide de revêtement.

8. Procédé selon la revendication 1, dans lequel le liquide de revêtement comprend en outre, en tant que co-initiateur, un composé hydrocarbure halogéné, un composé cétone, un composé cétoxime, un peroxyde organique, un composé thio, un hexaarylbiimidazole, un composé d'onium aromatique ou un éther d'oxime.

9. Procédé selon la revendication 1, dans lequel l'oxygène est fourni au liquide de revêtement en agitant le liquide de revêtement.

10. Procédé selon la revendication 1, dans lequel l'oxygène est fourni au liquide de revêtement en mettant en circulation le liquide de revêtement.

11. Procédé selon la revendication 1, dans lequel l'oxygène est fourni au liquide de revêtement en injectant de l'air dans le liquide de revêtement.
